# EUROPEAN PATENT APPLICATION

(11) **EP 2 610 899 A1**
(43) Date of publication of application: **03.07.2013**
(21) Application number: 11819797.9
(22) Date of filing: 10.08.2011
(51) Int. Cl.: H01L 21/368, H01L 21/336, H01L 29/786, H01L 51/05, H01L 51/40

(54) **METHOD AND DEVICE FOR FORMING ORGANIC THIN FILM, AND METHOD FOR MANUFACTURING OF ORGANIC DEVICE**

(30) Priority: 23.08.2010 JP 2010186436; 23.08.2010 JP 2010186435
(71) Applicant: Sony Corporation, Tokyo 108-0075 (JP)
(72) Inventor: GOTO Osamu, Tokyo 108-0075 (JP); HOBARA Daisuke, Tokyo 108-0075 (JP); NOMOTO Akihiro, Tokyo 108-0075 (JP); MURAKAMI Yosuke, Tokyo 108-0075 (JP); TOMIYA Shigetaka, Shiroishi-shi Miyagi 989-0734 (JP); KOBAYASHI Norihito, Tokyo 108-0075 (JP); SHIMIZU Keisuke, Tokyo 108-0075 (JP); KATSUHARA Mao, Tokyo 108-0075 (JP); OHE Takahiro, Tokyo 108-0075 (JP); KAWASHIMA Noriyuki, Tokyo 108-0075 (JP); TAKAHASHI Yuka, Tokyo 108-0075 (JP); FUKUDA Toshio, Tokyo 108-0075 (JP); ISHII Yui, Tokyo 108-0075 (JP)
(74) Representative: Müller - Hoffmann & Partner
(86) International application number: PCT/JP2011/068277
(87) International publication number: WO 2012/026333

(57) **Abstract**

There is provided a method of forming an organic thin film, capable of forming a single-crystal organic thin film easily and rapidly while controlling a thickness and a size. After an organic solution is supplied to one surface (a solution accumulating region wide in width, and a solution constricting region narrow in width and connected thereto) of a film-formation substrate supported by a support controllable in temperature, a movable body controllable in temperature independently of the support is moved along a surface of the support while being kept in contact with the organic solution. The temperature of the support is set at a temperature positioned between a solubility curve and a super-solubility curve concerning the organic solution, and the temperature of the movable body is set at a temperature positioned on a side higher in temperature than the solubility curve.

## Description

### Technical Field

The technology relates to a method of forming an organic thin film and an organic thin film forming apparatus, using an organic solution in which an organic material is dissolved in a solvent, as well as a method of manufacturing an organic device using the same.

### Background Art

In recent years, as a thin film to be used for a next-generation device having various uses, organic thin films have been actively researched and developed in place of inorganic thin films. This is because, since an organic thin film can be formed using a simple and inexpensive method such as coating and printing, it is possible to realize facilitation of manufacturing and reduction in cost for an organic device using the organic thin film. In addition, a bendable organic device can also be realized utilizing flexibility of an organic thin film.

However, in order to put an organic device using an organic thin film to practical use, as a matter of course, not only the above-mentioned facilitation of manufacturing and reduction in cost, but formation of an organic thin film having excellent film properties is desired to ensure original performance of the device. Therefore, a method of forming a single-crystal organic thin film has been studied.

Specifically, there has been proposed a method of forming an organic thin film by solution growth, through application of an organic solution in which an organic material is dissolved (for example, see NPL 1). In this method, an organic solution is dried in the air after being dropped to be next to a structure provided on a silicon board, and a crystal growth direction is controlled using the structure.

Further, a method of forming an organic thin film by vapor phase epitaxy has been proposed (for example, see NPL 2). In this method, after a thin film of octadecyl triethoxysilane (OTS) is transferred to a silicon oxide film by using a stamp of polydimethylsiloxane (PDMS), a crystal is grown on the film.

Furthermore, there has been proposed a method of forming an organic thin film by solution growth, through immersion of a substrate supported by a radiator in an organic solution (for example, see NPL 3). In this method, the temperature of the substrate is adjusted using the radiator, and a solute (an organic material) in the organic solution is crystallized on the surface of the substrate. In this method, however, it is conceivable that a bulk crystal is formed, because a crystal nucleus generated at random in the organic solution is deposited on the surface of the substrate, and a crystal grows from the crystal nucleus as the starting point.

### Citation List

### Patent Literature

NPL 1: Very High Mobility in Solution-Processed Organic Thin-Film Transistors of Highly Ordered [1] Benzothieno [3,2-b] benzothiophene Derivatives, Applied Physics Express, 2, 2009, p. 111501-1 to 3, Jun Takeya et al.
NPL 2: Patterning organic single-crystal transistor arrays, nature, Vol. 444, 14 December 2006, Alejandro L. Briseno et al.
NPL 3: Direct Formation of Thin Single Crystal of Organic Semiconductors onto a Substrate, CHEMISTRY OF MATERIALS, 19 (15), 2007, p. 3748-3753, Takeshi Yamao et al.

### Summary

As for recent electronic apparatuses represented by displays, there has been a trend toward more functions and higher performance. Therefore, in order to manufacture an organic device with stability by ensuring formation precision of an organic thin film, it is necessary to control the thickness and the size of the organic thin film. However, in an ordinary method of forming an organic thin film, although a single-crystal organic thin film can be formed, it is difficult to control the thickness and the size thereof strictly. In addition, it takes a long time to crystallize a solute in an organic solution by solution growth.

Besides, since there is a trend toward more functions and higher performance of recent electronic apparatuses represented by displays, formation of a single-crystal organic thin film is desired, as described above, and a proposal for formation method thereof has been proposed. However, in an ordinary method of forming an organic thin film, it is substantially difficult to form a single-crystal organic thin film, because a crystal-nucleus formation position and a crystal growth direction are not sufficiently controlled.

In particular, in an ordinary method using a structure provided on a silicon board, an organic thin film is formed for every structure, but the crystal-nucleus formation position easily changes due to variations in drip of an organic solution, evaporation rate of a solvent, and the like. For this reason, it is difficult to control the crystal-nucleus formation position and the crystal growth direction precisely.

In addition, in an ordinary method using a radiator, since crystal nuclei randomly generated in an organic solution merely adhere to the surface of a substrate, it is still difficult to control the crystal-nucleus formation position and the crystal growth direction. In the first place, it is conceivable that a crystal formed by this method is bulk, not a thin film.

The technology is made in view of the above-described issues, and it is an object thereof to provide a method of forming an organic thin film and an organic thin film forming apparatus, as well as a method of manufacturing an organic device, which make it possible to form a single-crystal organic thin film rapidly and easily, while controlling a thickness and a size.

Further, it is another object of the technology to provide a method of forming an organic thin film and an organic thin film forming apparatus, as well as a method of manufacturing an organic device, which make it possible to form a single-crystal organic thin film by controlling a crystal-nucleus formation position and a crystal growth direction.

A first method of forming an organic thin film of the technology is a method including: supplying an organic solution containing a solvent and an organic material dissolved therein to a solution accumulating region and a solution constricting region connected thereto on one surface of a film-formation substrate supported by a support controllable in temperature; and moving a movable body along a surface of the support while bringing the movable body in contact with the organic solution, the movable body being disposed opposite the support to be spaced apart from the film-formation substrate, and being controllable in temperature independently of the support. In this case, a width of the solution constricting region is smaller than a width of the solution accumulating region, and the solution constricting region is arranged behind the solution accumulating region in a moving direction of the movable body. Further, the temperature of the support is set at a temperature between a solubility curve (concentration versus temperature) and a super-solubility curve (concentration versus temperature), and the temperature of the movable body is set at a temperature on a side higher in temperature than the solubility curve.

An organic thin film forming apparatus of the technology is an apparatus including: a film-formation substrate; a support supporting the film-formation substrate and being controllable in temperature; and a movable body disposed opposite the support to be spaced apart from the film-formation substrate, and the movable body being movable along a surface of the support and controllable in temperature independently of the support. The film-formation substrate has, on one surface, a solution accumulating region and a solution constricting region connected thereto to which an organic solution containing a solvent and an organic material dissolved therein is supplied, and a width of the solution constricting region is smaller than a width of the solution accumulating region, and the solution constricting region is arranged behind the solution accumulating region in a moving direction of the movable body. The movable body moves while being in contact with the organic solution supplied to the solution accumulating region and the solution constricting region.

A first method of manufacturing an organic device of the technology uses, in order to manufacture an organic device using an organic thin film, the first method of forming the organic thin film or the organic thin film forming apparatus of the technology described above.

A second method of forming an organic thin film of the technology is based on the following procedure. (1) There are prepared an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region that is connected thereto and has a width smaller than a width of the solution accumulating region on one surface. (2) The organic solution is supplied to the solution accumulating region and the solution constricting region, so that a temperature TS of the organic solution becomes a temperature T1 positioned on a side higher in temperature than the solubility curve, and a vapor pressure P in an environment surrounding the organic solution becomes a saturated steam pressure at the temperature T1. (3) The temperature TS is lowered from the temperature T1 to a temperature T2 positioned between the solubility curve and the super-solubility curve. It is to be noted that a second method of manufacturing an organic device of the technology uses, in order to manufacture an organic device using an organic thin film, the second method of forming the organic thin film described above.

A third method of forming an organic thin film of the technology is based on the following procedure. (1) There are prepared an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region that is connected thereto and has a width smaller than a width of the solution accumulating region on one surface. (2) The organic solution is supplied to the solution accumulating region and the solution constricting region, so that a temperature TS of the organic solution becomes a temperature T2 positioned between the solubility curve and the super-solubility curve, and a vapor pressure P in an environment surrounding the organic solution becomes a saturated steam pressure at the temperature T2. (3) The vapor pressure P is lowered. It is to be noted that a third method of manufacturing of an organic device of the technology uses, in order to manufacture an organic device using an organic thin film, the third method of forming the organic thin film described above.

According to the first method of forming the organic thin film and the organic thin film forming apparatus of the technology, after the organic solution is supplied to the one surface (the solution accumulating region wide in width, and the solution constricting region narrow in width and connected thereto) of the film-formation substrate supported by the support, the movable body is moved along the surface of the support while being kept in contact with the organic solution. The temperature of this support is set at the temperature positioned between the solubility curve and the super-solubility curve concerning the organic solution, and the temperature of the movable body is set at the temperature positioned on the side higher in temperature than the solubility curve. In this case, each part of the organic solution is heated by the movable body of high temperature and cooled by the support of low temperature in response to the movement of the movable body, and therefore, a temperature gradient gradually increasing in the moving direction of the movable body occurs in the organic solution. In addition, since supersaturation of the organic solution locally rises in proximity to a connection position between the solution accumulating region and the solution constricting region, a crystal nucleus is formed in a small range at a part on a lower temperature side, and at a part on a higher temperature side, a crystal grows from the crystal nucleus formed at the part on the lower temperature side, as the starting point, in the organic solution having the temperature gradient. Therefore, a single-crystal organic thin film is formed by solution growth using the organic solution. Besides, the thickness of the organic thin film is controlled according to the distance between the film-formation substrate and the movable body, and the size of the organic thin film is controlled according to the planar shape of the solution accumulating region and the solution constricting region. Moreover, since the movable body higher in temperature than the support comes in contact with the organic solution, the time necessary for evaporation of the solvent in the organic solution (crystallization of a solute) is reduced. Therefore, it is possible to form the single-crystal organic thin film rapidly and easily while controlling the thickness and the size thereof.

Further, according to the first method of manufacturing the organic device of the technology, since the organic thin film is formed using the first method of forming the organic thin film or the organic thin film forming apparatus of the technology, the thickness and the size of the organic thin film are controlled, and the organic thin film is formed rapidly and easily. Therefore, it is possible to manufacture the organic device stably, rapidly, and easily.

According to the second method of forming the organic thin film of the technology, after the organic solution is supplied to the solution accumulating region wide in width and the solution constricting region narrow in width connected thereto, so that the temperature TS of the organic solution becomes the temperature T1, and the vapor pressure P becomes the saturated steam pressure at the temperature T1, the temperature TS is lowered from the temperature T1 to the temperature T2. This temperature T1 is a temperature positioned on a side higher in temperature than the solubility curve, and the temperature T2 is a temperature positioned between the solubility curve and the super-solubility curve. In this case, due to a decrease in the temperature TS of the organic solution, the supersaturation of the organic solution locally rises in proximity to a connection position between the solution accumulating region and the solution constricting region. As a result, a crystal nucleus is formed in a small range in the organic solution, and a crystal grows from the crystal nucleus as the starting point, and thus, a single-crystal organic thin film is formed. Therefore, it is possible to from a single-crystal organic thin film by controlling a crystal-nucleus formation position and a crystal growth direction.

According to the third method of forming the organic thin film of the technology, after the organic solution is supplied to the solution accumulating region wide in width and the solution constricting region narrow in width and connected thereto, so that the temperature TS of the organic solution becomes the temperature T2, and the vapor pressure P becomes the saturated steam pressure at the temperature T2, the vapor pressure P is lowered. This temperature T2 is a temperature positioned between the solubility curve and the super-solubility curve. In this case, due to a drop in the vapor pressure P, the supersaturation of the organic solution locally rises in proximity to a connection position between the solution accumulating region and the solution constricting region. As a result, a crystal nucleus is formed in a small range in the organic solution, and a crystal grows from the crystal nucleus as the starting point, and thus, a single-crystal organic thin film is formed. Therefore, it is possible to from a single-crystal organic thin film by controlling a crystal-nucleus formation position and a crystal growth direction.

Furthermore, according to the second or third method of manufacturing the organic device of the technology, it is possible to improve performance of the organic device, since the above-described second or third method of forming the organic thin film of the technology is used.

### Brief Description of Drawings

[FIG. 1] FIG. 1 illustrates a block cross-sectional diagram and a plan view depicting a configuration of an organic thin film forming apparatus in an embodiment of the technology.
[FIG. 2] FIG. 2 is a plan view depicting a configuration of a film-formation substrate used in a method of forming an organic thin film.
[FIG. 3] FIG. 3 illustrates a cross-sectional diagram and a plan view intended to explain one process in the method of forming the organic thin film.
[FIG. 4] FIG. 4 illustrates a cross-sectional diagram and a plan view intended to explain a process following FIG. 3.
[FIG. 5] FIG. 5 illustrates a cross-sectional diagram and a plan view intended to explain a process following FIG. 4.
[FIG. 6] FIG. 6 illustrates a cross-sectional diagram and a plan view intended to explain a process following FIG. 5.
[FIG. 7] FIG. 7 illustrates a cross-sectional diagram and a plan view intended to explain a process following FIG. 6.
[FIG. 8] FIG. 8 is a diagram intended to explain formation conditions of an organic thin film.
[FIG. 9] FIG. 9 is a plan view depicting a modification concerning a planar shape of a solution accumulating region and a solution constricting region.
[FIG. 10] FIG. 10 is a plan view intended to explain a modification concerning the method of forming the organic thin film.
[FIG. 11] FIG. 11 illustrates a cross-sectional diagram and a plan view intended to explain other modification concerning the method of forming the organic thin film.
[FIG. 12] FIG. 12 illustrates a cross-sectional diagram and a plan view intended to explain a process following FIG. 11.
[FIG. 13] FIG. 13 is a cross-sectional diagram depicting a configuration of an apparatus (a film-formation apparatus) used in a method of forming an organic thin film in an embodiment of the present invention.
[FIG. 14] FIG. 14 is a plan view depicting a configuration of a film-formation substrate used in the method of forming the organic thin film.
[FIG. 15] FIG. 15 is a cross-sectional diagram intended to explain one process in the method of forming the organic thin film.
[FIG. 16] FIG. 16 is a plan view corresponding to FIG. 15.
[FIG. 17] FIG. 17 is a plan view intended to explain a process following FIG. 16.
[FIG. 18] FIG. 18 is a plan view intended to explain a process following FIG. 17.
[FIG. 19] FIG. 19 is a plan view intended to explain a process following FIG. 18.
[FIG. 20] FIG. 20 is a diagram intended to explain formation conditions of an organic thin film.
[FIG. 21] FIG. 21 is a plan view depicting a modification concerning the configuration of the film-formation substrate.
[FIG. 22] FIG. 22 is a plan view depicting other modification concerning the configuration of the film-formation substrate.
[FIG. 23] FIG. 23 is a cross-sectional diagram intended to explain a configuration of an organic device and a manufacturing method to which the organic thin film forming apparatus and the method of forming the organic thin film are applied.
[FIG. 24] FIG. 24 is a cross-sectional diagram depicting a modification concerning the configuration of the organic device.
[FIG. 25] FIG. 25 is a cross-sectional diagram depicting another modification concerning the configuration of the organic device.
[FIG. 26] FIG. 26 is a cross-sectional diagram depicting still another modification concerning the configuration of the organic device.
[FIG. 27] FIG. 27 is a photomicrograph depicting an experimental result concerning the method of forming the organic thin film.
[FIG. 28] FIG. 28 illustrates optical photomicrographs each depicting an enlarged main part shown in FIG. 27.

### Description of Embodiments

Embodiments of the technology will be described below in detail with reference to the drawings. It is to be noted that the order in which the description will be provided is as follows.
1. Method of Forming Organic Thin Film and Organic Thin Film Forming Apparatus
   1-1. Formation Apparatus
   1-2. Formation Method
2. Other Methods of Forming Organic Thin Film
   2-1. Solution-Temperature Controlling Type
   2-2. Vapor-Pressure Controlling Type
3. Method of Manufacturing Organic Device

### <1. Method of Forming Organic Thin Film and Organic Thin Film Forming Apparatus>

### <1-1. Formation Apparatus>

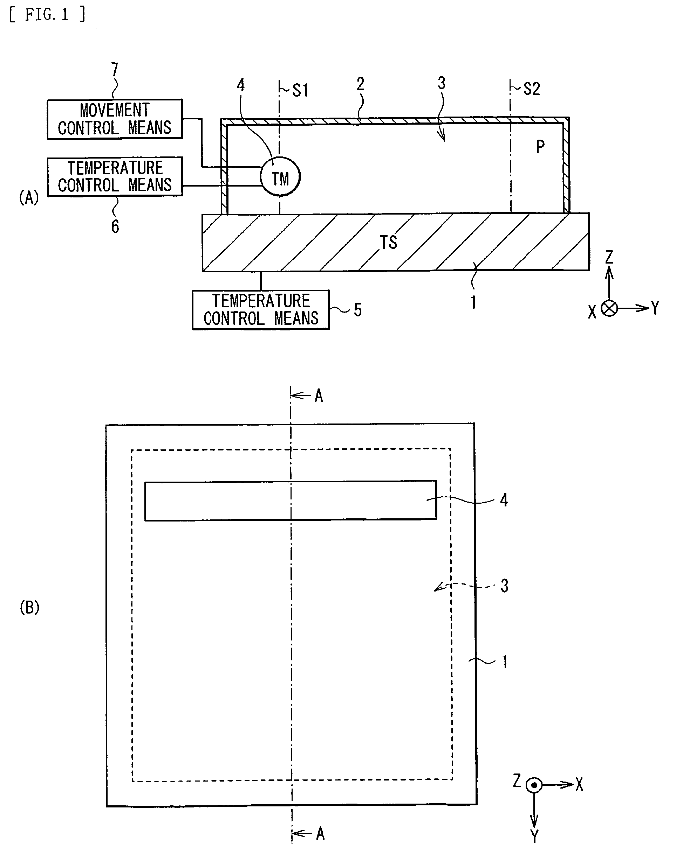

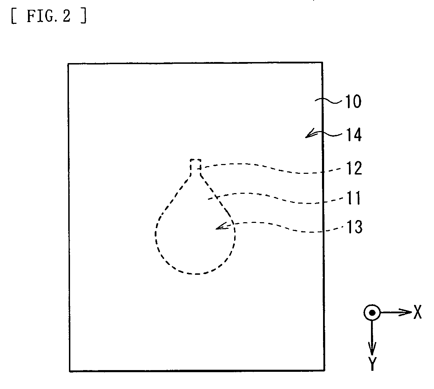

First, a configuration of an organic thin film forming apparatus (which will be hereinafter referred to as a "film-formation apparatus") in an embodiment of the technology will be described. FIG. 1 depicts a block cross-sectional configuration (A) and a plane configuration (B) of the film-formation apparatus, and (A) of FIG. 1 illustrates a cross section taken along a line A-A illustrated in (B) of FIG. 1. FIG. 2 depicts a plane configuration of a film-formation substrate 10 used to form an organic thin film.

The film-formation apparatus described here is an apparatus used to form a single-crystal organic thin film through solution growth, by supplying (applying) an organic solution to one surface of the film-formation substrate 10, a so-called bar coater. It is to be noted that the organic solution contains a solvent and an organic material dissolved therein, and may contain materials other than those as necessary.

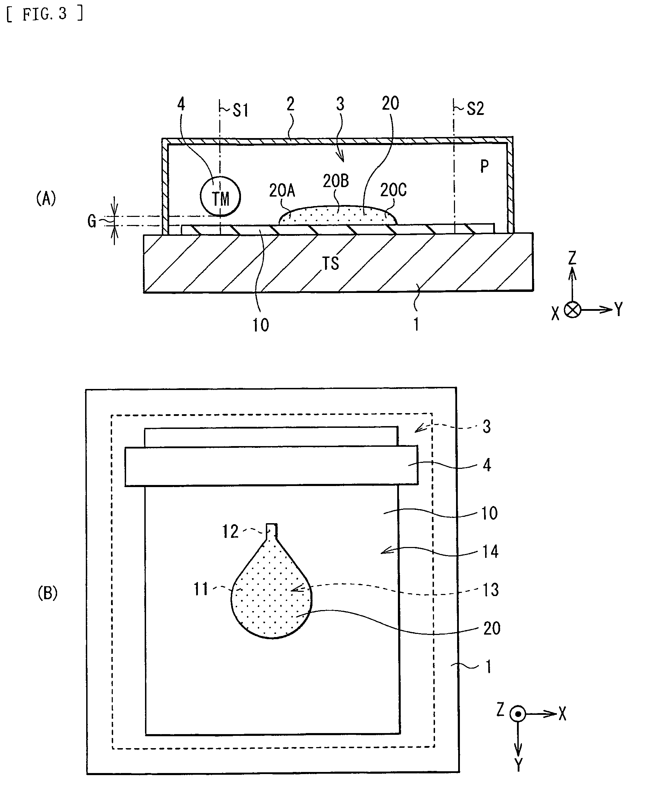

This film-formation apparatus includes, for example, as illustrated in FIG. 1, a support 1 covered by a hood 2, a movable body 4 housed in a space (a film-formation room 3) surrounded by the support 1 and the hood 2, a temperature control means 5 that controls a temperature TS of the support 1, and a temperature control means 6 as well as a movement control means 7 that control a temperature TM and movement of the movable body 4, respectively. In this film-formation room 3, the film-formation substrate 10 is also housed with the movable body 4. It is to be noted that, in (B) of FIG. 1, illustration of the hood 2, the temperature control means 5 and 6, as well as the movement control means 7 are omitted, which also applies to FIG. 3 that will be described later.

The support 1 is what supports the film-formation substrate 10. The temperature control means 5 includes, for example, a heater, and controls the temperature TS of the support 1 to a desired temperature. It is to be noted that the support 1 and the temperature control means 5 may be a one-piece component, or separate components. Here, the support 1 and the temperature control means 5 are, for example, provided as a one-piece component such as a susceptor having a temperature control function.

The hood 2 is what seals the film-formation room 3, and is formed of, for example, glass. By this, a pressure (a vapor pressure) P in the film-formation room 3 is maintained at a desired vapor pressure.

The movable body 4 is, for example, a so-called bar for a bar coater, and is formed of, for example, copper (Cu) plated with chromium (Cr). This movable body 4 is disposed opposite the support 1, and spaced apart from the support 1. In addition, the movable body 4 has, for example, a three-dimensional shape which is a substantially circular cylinder extending along a surface of the support 1, and is movable in a direction (a Y-axis direction) intersecting an extending direction (a X-axis direction) thereof while maintaining a height (a distance between the support 1 and the movable body 4). A moving range of this movable body 4 extends from a position S 1 on one-end side of the support 1 to a position S2 on the other-end side. However, the three-dimensional shape of the movable body 4 is not necessarily limited to the substantially circular cylinder shape. It is to be noted that, when the organic solution is supplied to the one surface of the film-formation substrate 10, the movable body 4 moves while being in contact with the organic solution.

The temperature control means 6 includes, for example, a heater, and controls a temperature TM of the movable body 4 to a desired temperature. However, the temperature control means 6 is capable of controlling the temperature TM of the movable body 4 independently of the temperature TS of the support 1. The movement control means 7 includes, for example, a motor, and controls a moving velocity of the movable body 4 to a desired moving velocity.

The film-formation substrate 10 is a substrate onto which the organic solution is supplied and the organic thin film is formed, and may be, for example, a board made of glass, a plastic material, a metallic material, or the like, or may be a film made of a plastic material, a metallic material, or the like. It is to be noted that the film-formation substrate 10 may be a substrate in which various films in one layer or two or more layers are provided on the above-mentioned board or film.

The film-formation substrate 10 has, as illustrated in FIG. 2, a solution accumulating region 11 to which the organic solution is supplied and a solution constricting region 12 connected thereto, which are provided on a surface on one side where the organic thin film is to be formed. The solution accumulating region 11 is a region intended to accumulate the organic solution which will be consumed to form the organic thin film, and the solution constricting region 12 is a region intended to constrict the organic solution supplied to the solution accumulating region 11. However, the width of the solution constricting region 12 is smaller than the width of the solution accumulating region 11, and the solution constricting region 12 is provided behind the solution accumulating region 11 (on a side closer to the position S 1 which is a movement start position of the movable body 4) in a moving direction of the movable body 4.

The film-formation substrate 10 has the solution accumulating region 11 which is wide in width and the solution constricting region 12 which is narrow in width, so as to cause a difference in area of a liquid phase (of the organic solution) contacting a vapor phase (atmosphere or steam in the film-formation room 3). In the solution accumulating region 11 in which an area contacting the vapor phase is large (the width is wide), the solvent in the organic solution easily evaporates, whereas in the solution constricting region 12 in which an area contacting the vapor phase is small (the width is narrow), the solvent in the organic solution is resistant to evaporating. This locally accelerates the evaporation of the solvent in proximity to a connection position between the solution accumulating region 11 and the solution constricting region 12 and thus, degree of supersaturation of the organic solution increases locally. In the technology, in order to form the organic thin film by the solution growth through the use of the organic solution, a solute (an organic material) in the organic solution is crystallized using the above-described local increase in the degree of supersaturation. Details of this mechanism of forming the organic thin film will be described later.

In particular, the film-formation substrate 10 has, for example, as illustrated in FIG. 2, a lyophilic region 13 and a liquid-repellent region 14 on the one surface, and it is preferable that the solution accumulating region 11 and the solution constricting region 12 described above be the lyophilic region 13. In this case, the solution accumulating region 11 and the solution constricting region 12 are lyophilic (the lyophilic region 13) with respect to the organic solution, whereas other region is liquid repellent (the liquid-repellent region 14) with respect to the organic solution. Here, the number of the lyophilic regions 13 (the number of the sets of the solution accumulating region 11 and the solution constricting region 12) is, for example, one (one set).

The lyophilic region 13 is a region that easily becomes wet with respect to the organic solution, and has a property of fixing the organic solution onto the surface of the film-formation substrate 10. On the other hand, the liquid-repellent region 14 is a region that is resistant to becoming wet with respect to the organic solution, and has a property of rejecting the organic solution on the surface of the film-formation substrate 10. The film-formation substrate 10 having the lyophilic region 13 and the liquid-repellent region 14 may be, for example, a substrate in which a liquid-repellent surface treatment or a liquid-repellent film formation treatment is applied to a lyophilic board or the like, or may be a substrate in which a lyophilic surface treatment or a lyophilic film formation treatment is applied to a liquid-repellent board or the like. In the former case, a region to which the surface treatment is applied becomes the liquid-repellent region 14, and other region becomes the lyophilic region 13. In the latter case, a region to which the surface treatment is applied becomes the lyophilic region 13, and other region becomes the liquid-repellent region 14. One example is that the film-formation substrate 10 is a substrate in which an amorphous fluororesin film (CYTOP manufactured by Asahi Glass Co., Ltd.) is partially formed on an organic insulating film (a polyvinylpyrrolidone film) provided to cover one surface of a silicon board. In other words, a region where the amorphous fluororesin film is formed is the liquid-repellent region 14, and other region is the lyophilic region 13.

The film-formation substrate 10 has the lyophilic region 13 and the liquid-repellent region 14, so as to fix the organic solution to a desired region (the lyophilic region 13) by utilizing a difference in wettability. A range in which the organic solution is present is precisely controlled by this. It is to be noted that the wettability (surface energy) of the lyophilic region 13 and that of the liquid-repellent region 14 may be different to the extent that the organic solution can be fixed to the lyophilic region 13.

A planar shape of the solution accumulating region 11 and the solution constricting region 12 is freely settable, as long as a size relation in terms of width and a positional relation as described above are established therebetween. Above all, it is preferable that the planar shape of the solution accumulating region 11 and the solution constricting region 12 correspond to a planar shape of the organic thin film. This is because, since the planar shape of the organic thin film is determined according to the range in which the organic solution is present on the surface of the film-formation substrate 10, the planar shape of the organic thin film can be controlled to a desired shape.

Here, the solution accumulating region 11 has, for example, a planar shape of a drop type (a teardrop type), and the width thereof narrows after widening in the moving direction of the movable body 4. Further, the solution constricting region 12 has, for example, a planar shape of a rectangular type, and the width thereof is constant in the moving direction of the movable body 4.

It is to be noted that the film-formation apparatus may include, other than those described above, components not-illustrated. As such other components, there is, for example, a solution pump intended to supply the organic solution.

### <1-2. Formation Method>

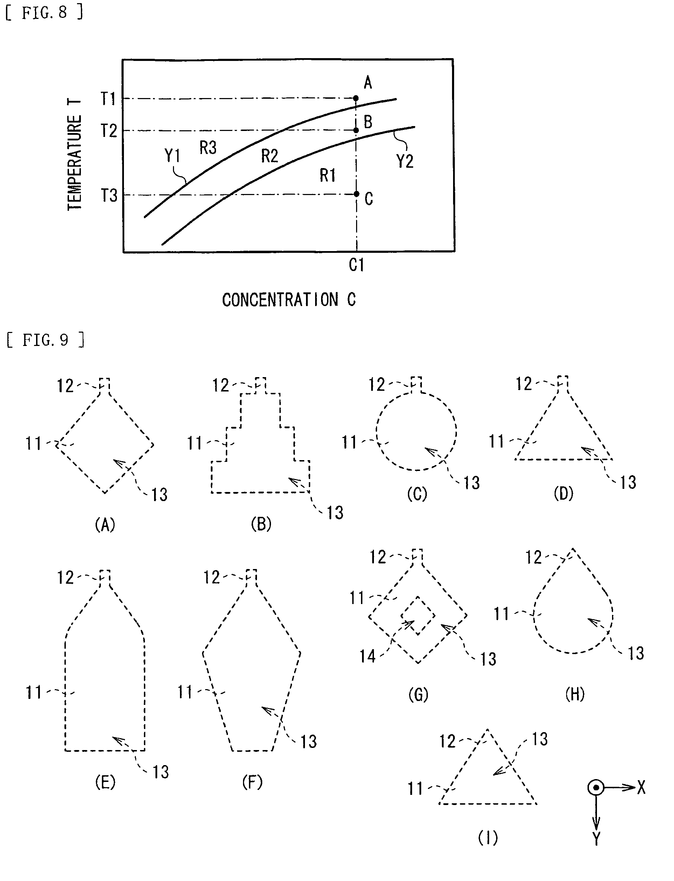

A method of forming an organic thin film using the film-formation apparatus will be described. FIG. 3 to FIG. 7 are intended to explain a formation process of an organic thin film 30, and each depict a cross-sectional configuration and a plane configuration corresponding to FIG. 1. Further, FIG. 8 depicts a solubility curve Y1 and a super-solubility curve Y2 concerning an organic solution 20 to explain formation conditions of an organic thin film 30, and a horizontal axis and a vertical axis indicate a concentration C and a temperature T, respectively.

When the organic thin film 30 is formed, first, as illustrated in FIG. 3, the movable body 4 is caused to wait at the position S1, and the film-formation substrate 10 is fixed onto the support 1. In this case, the thickness of the organic thin film 30 is determined according to a height (a distance between the film-formation substrate 10 and the movable body 4) G of the movable body 4 and thus, the height G is adjusted to be a desired value.

It is to be noted that, it is preferable to adjust the vapor pressure P, by filling the film-formation room 3 with steam of a solvent (a co-solvent) of the same type as that of the organic solution 20. This is to suppress an influence of the vapor pressure P on an amount of evaporation of the solvent. In this case, for example, a container such as a beaker containing the co-solvent may be placed on the support 1, together with the film-formation substrate 10. This is because the temperature of the organic solution 20 and the temperature of the co-solvent are controlled together by the support 1. However, the film-formation room 3 may be filled with other gas (for example, nitrogen gas) of one kind, or two or more kinds, together with the steam of the co-solvent.

Subsequently, the organic solution 20 (an arbitrary concentration C1: FIG. 8) is supplied to the one surface (the solution accumulating region 11 and the solution constricting region 12) of the film-formation substrate 10. In this case, for example, the organic solution 20 is supplied to the solution accumulating region 11, and the organic solution 20 is caused to flow from the solution accumulating region 11 into the solution constricting region 12. Since the solution accumulating region 11 and the solution constricting region 12 are lyophilic (the lyophilic region 13) with respect to the organic solution, the organic solution 20 fills the solution accumulating region 11 and the solution constricting region 12. The feed rate of the organic solution 20 may be any rate, as long as at least the solution accumulating region 11 and the solution constricting region 12 can be filled.

FIG. 3 to FIG. 6 illustrate a part that first comes in contact with the movable body 4 (a one-end part 20A) and a part that comes in contact with the movable body 4 afterwards (a central part 20B and an other-end part 20C), of the organic solution 20, to explain a mechanism of forming the organic thin film 30 in a post process. This one-end part 20A is, for example, present in the solution constricting region 12.

Although the type of the solvent used to prepare the organic solution 20 is not limited in particular as long as it is a liquid in which an organic material serving as the solute can be dissolved, above all, an organic solvent in which many kinds of organic materials can be dissolved easily and stably while having superior volatility is preferable. In addition, the type of the organic material is freely selectable according to functions and the like of the organic thin film 30. On example is that the organic material is an organic semiconductor material in which, for instance, electrical properties (electron mobility and the like) change according to a crystal growth direction (a sequence direction of organic molecules).

Here, the temperature TS of the support 1 and the temperature TM of the movable body 4 are set based on the solubility curve Y1 and the super-solubility curve Y2 illustrated in FIG. 8. For this reason, it is preferable that the solubility curve Y1 and the super-solubility curve Y2 be prepared (measured) in advance before work of forming the organic thin film 30 is performed, for an organic material to be used to form the organic thin film 30 and a solvent in which it is to be dissolved.

Ranges R1 to R3 illustrated in FIG. 8 each depict a state of the organic solution 20. The range R3 on a side higher in temperature than the solubility curve Y1 is the state in which a crystal dissolves (a solution state). The range R2 between the solubility curve Y1 and the super-solubility curve Y2 is the state in which crystal growth starts from a crystal nucleus (a crystal growth state) as the starting point. The range R1 on a side lower in temperature than the super-solubility curve Y2 is the state in which a crystal nucleus is formed (a crystal nucleation state). It is to be noted that, a point A to a point C each represent an example of a temperature condition in forming the organic thin film 30.

The temperature TS of the support 1 is a temperature positioned (in the range R2) between the solubility curve Y1 and the super-solubility curve Y2, and is, to be more specific, for example, set at T2 corresponding to the point B. On the other hand, the temperature TM of the movable body 4 is a temperature positioned on the side (in the range R3) higher in temperature than the solubility curve Y1, and is, to be more specific, for example, set at T1 corresponding to the point A. In this case, it is preferable that the vapor pressure P in the film-formation room 3 be a saturated steam pressure at the temperature T2. This is because unintentional evaporation of the solvent in the organic solution 20 can be suppressed, since a solution layer (the organic solution 20) and the vapor phase (steam) reach equilibrium.

In the state in which the organic solution 20 is supplied to the one side of the film-formation substrate 10, the support 1 is indirectly in contact with the organic solution 20 through the film-formation substrate 10, whereas the movable body 4 is not in contact with the organic solution 20. For this reason, the temperature T in the initial state of the organic solution 20 is equal to the temperature TS (= T2) of the support 1. Thus, although the organic solution 20 is in the crystal growth state (the range R2), the crystal growth does not take place because the crystal nucleus is not yet formed in the organic solution 20.

The reason that the temperature TS of the support 1 is made equal to T2 is that, when the temperature TS is set at a temperature positioned on the side (in the range R1) lower in temperature than the super-solubility curve Y2, e.g., the T3 corresponding the point C, the organic solution 20 is in the crystal nucleation state from the beginning. This forms crystal nuclei in the organic solution 20 at random, thereby forming a bulk crystal.

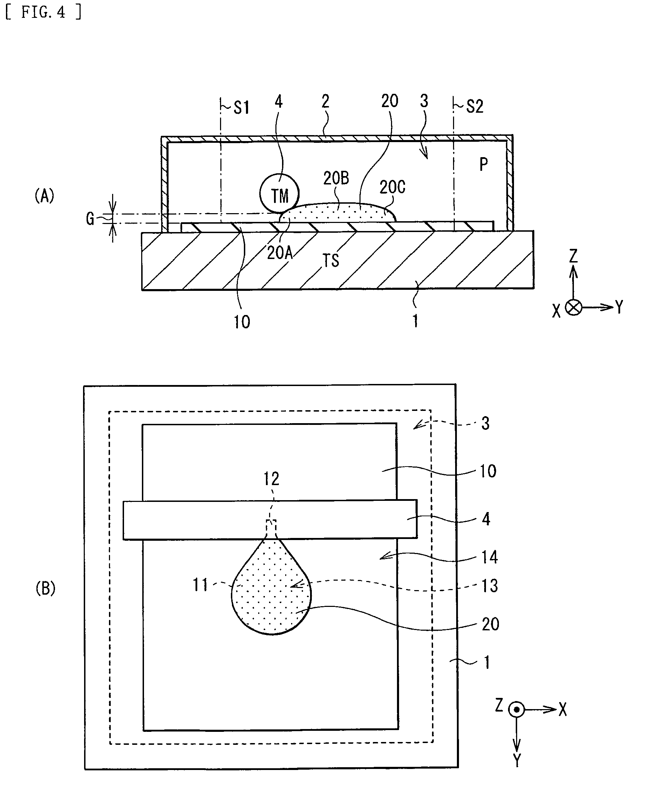

Subsequently, the movable body 4 is moved from the position S1 to the position S2 as illustrated in FIG. 4 to FIG. 6. In this case, of the organic solution 20, the temperatures T of parts being in contact with the movable body 4 higher in temperature than the support 1 rise sequentially, and the temperatures T of parts after the contact (after passage of the movable body 4) are sequentially lowered by the support 1. For this reason, in the organic solution 20, a gradient of a temperature gradually increasing in the moving direction of the movable body 4 occurs. Therefore, a crystal nucleus is formed in the organic solution 20, and a crystal grows from the crystal nucleus as the starting point.

Specifically, when the movable body 4 moves from the position S 1 to the position S2, the movable body 4 (the temperature TM = T1) higher in temperature than the support 1 (the temperature TS = T2) first comes in contact with the one-end part 20A of the organic solution 20 as illustrated in FIG. 4. As a result, the one-end part 20A is heated by the movable body 4, and the temperature T thereof increases from T2 to T1, and thus, the one-end part 20A enters the solution state (the range R3).

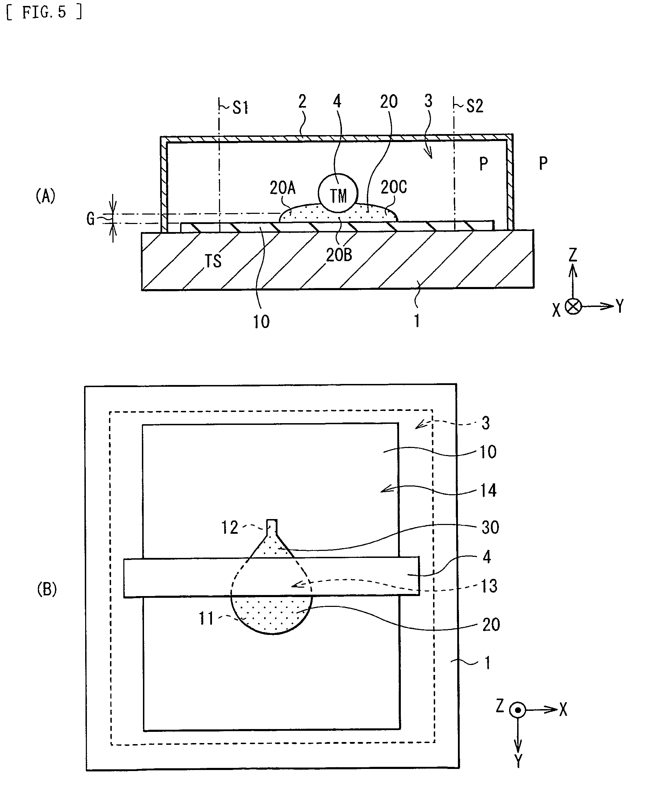

When the movable body 4 reaches the middle of the organic solution 20, the movable body 4 then comes in contact with the central part 20B following the one-end part 20A, as illustrated in FIG. 5. In this case, the central part 20B is heated by the movable body 4 whose temperature is high, while the one-end part 20A is cooled by the support 1 whose temperature is low, and therefore, a gradient of a temperature gradually increasing from the one-end part 20A towards the central part 20B occurs in the organic solution 20. As a result, the temperature T of the central part 20B increases from T2 to T1 and thus, the central part 20B enters the solution state (the range R3). On the other hand, the temperature T of the one-end part 20A falls from T1 to T2 and thus, the one-end part 20A returns to the crystal growth state (the range R2).

Here, in the one-end part 20A returning to the crystal growth state, a crystal nucleus has not yet been formed and therefore, normally, neither the formation of the crystal nucleus nor the crystal growth should occur. However, in the one-end part 20A, a crystal nucleus is formed in the organic solution 20 and a crystal grows from the crystal nucleus as the starting point, for the following reason.

The organic solution 20 is present in the solution accumulating region 11 which is wide in width and the solution constricting region 12 which is narrow in width, and thus is constricted in the solution constricting region 12 as compared with the solution accumulating region 11. Therefore, a difference in area contacting the vapor phase occurs, between the organic solution 20 existing in the solution accumulating region 11 and the organic solution 20 existing in the solution constricting region 12, as described above. For this reason, the solvent in the organic solution 20 easily evaporates in the solution accumulating region 11 in which the area contacting the vapor phase is large, whereas the solvent in the organic solution 20 is resistant to evaporation in the solution constricting region 12 in which the area contacting the vapor phase is small. A difference in evaporation rate occurs in response to this difference in the area contacting the vapor phase, and the evaporation of the solvent locally accelerates in proximity to the connection position in the organic solution 20, and therefore, degree of supersaturation of the organic solution 20 increases locally. Thus, in a region where the degree of supersaturation has increased locally, the organic solution 20 is in a state similar to the crystal nucleation state on the side (the range R1) lower in temperature than the super-solubility curve Y2, and therefore, the solute in the organic solution 20 crystallizes. As a result, a crystal nucleus is formed in a small range (in proximity to the connection position) in the organic solution 20. Further, due to a diffusion phenomenon of the solute in the organic solution 20, a crystal grows from the crystal nucleus as the starting point, while being supplied with the solute from the organic solution 20. The single-crystal organic thin film 30 is thereby formed. In this case, a substantially single crystal nucleus is formed when the width of the solution constricting region 12 is sufficiently narrow.

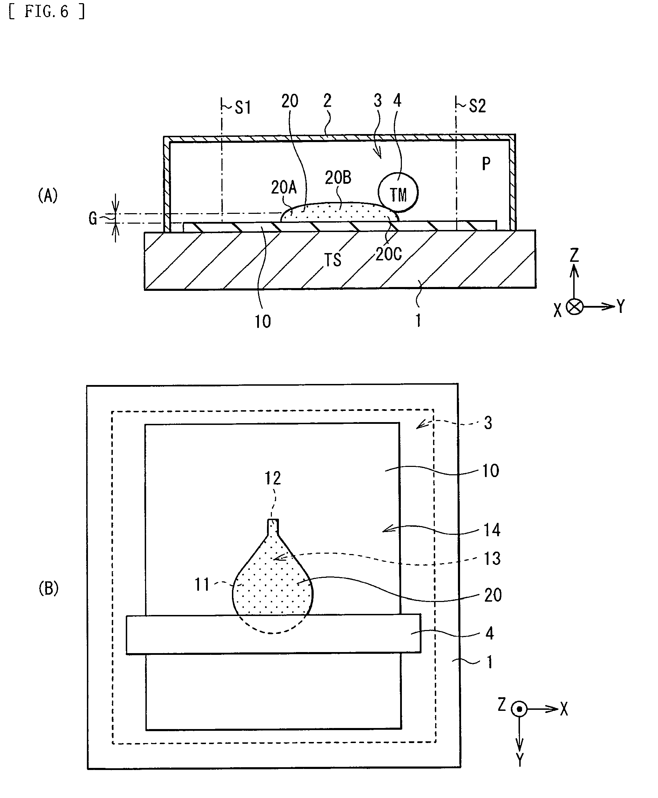

Subsequently, when the movable body 4 moves further, the movable body 4 then comes in contact with the other-end part 20C following the central part 20B, as illustrated in FIG. 6. In this case, since the other-end part 20C is heated by the movable body 4 whose temperature is high, and the central part 20B is cooled by the support 1 whose temperature is low, a gradient of a temperature gradually increasing from the one-end part 20A towards the other-end part 20C occurs in the organic solution 20. This increases the temperature T of the other-end part 20C from T2 to T1 and thus, the other-end part 20C enters the solution state (the range R3). On the other hand, the temperature T of the central part 20B falls from T1 to T2 and thus, the central part 20B returns to the crystal growth state (the range R2).

Therefore, in the central part 20B returning to the crystal growth state, a crystal nucleus should be formed by the reason similar to that of the case described for the one-end part 20A returning to the crystal growth state earlier. However, since the crystal nucleus has been already formed in the one-end part 20A, a crystal in the central part 20B will grow from the crystal nucleus, which has been already formed in the one-end part 20A, as the starting point. For this reason, in the organic solution 20, the solute is continually crystallized in the moving direction of the movable body 4, i.e. from the one-end part 20A towards the other-end part 20C.

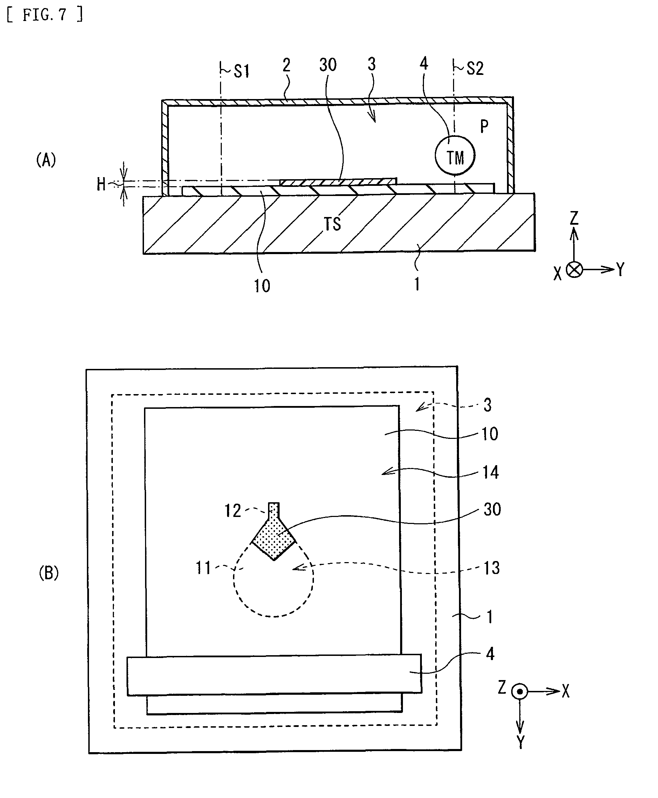

Finally, when the movable body 4 reaches the position S2, the above-described continuous crystal growth in the organic solution 20 is completed as illustrated in FIG. 7. Thus, the organic thin film 30 having a thickness H is formed in the lyophilic region 13 on the one surface of the film-formation substrate 10. Here, for example, the organic thin film 30 is formed to occupy the entire solution accumulating region 11 and a part of the solution constricting region 12, of the solution accumulating region 11 and the solution constricting region 12. However, a formation range of the organic thin film 30 is not necessarily limited to this.

It is to be noted that, here, in order to simplify the description and contents of illustration, the organic thin film 30 is assumed to be formed when the movable body 4 reaches the position S2. Actually, however, as apparent from the above-described mechanism of forming the organic thin film 30, the organic thin film 30 is sequentially formed from the one-end part 20A towards the other-end part 20C according to the movement of the movable body 4.

### [Functions and Effects of Method of Forming Organic Thin Film and Organic Thin Film Forming Apparatus]

In the method of forming the organic thin film and the organic thin film forming apparatus, after the organic solution 20 is supplied to the one surface (the solution accumulating region 11 which is wide in width, and the solution constricting region 12 which is connected thereto and narrow in width) of the film-formation substrate 10 supported by the support 1 (the temperature TS), the movable body 4 (the temperature TM) is moved along the surface of the support 1 while being kept in contact with the organic solution 20. The temperature TS of this support 1 is set at the temperature T2 positioned (in the range R2) between the solubility curve Y1 and the super-solubility curve Y2, and the temperature TM of the movable body 4 is set at the temperature T positioned on a side higher in temperature than the solubility curve Y1 (the range R3).

In this case, as described with reference to FIG. 1 to FIG. 8, the gradient of the temperature gradually increasing from the one-end part 20A towards the other-end part 20C occurs in the organic solution 20, and the degree of supersaturation of the organic solution 20 increases locally in proximity to the connection position between the solution accumulating region 11 and the solution constricting region 12. As a result, the crystal nucleus is formed in the small range in the one-end part 20A, and the crystal grows from the crystal nucleus formed in the one-end part 20A, as the starting point in the central part 20B and the other-end part 20C. For this reason, the single-crystal organic thin film 30 is formed by solution growth using the organic solution 20.

In addition, since the amount of the organic solution 20 (the solute) used for the formation of the organic thin film 30 is determined by the distance G between the film-formation substrate 10 and the movable body 4, the thickness H of the organic thin film 30 is controlled according to the distance G. Moreover, since the formation range of the organic thin film 30 is determined by a formation range of the solution accumulating region 11 and the solution constricting region 12, the size of the organic thin film 30 is controlled according to the planar shape of the solution accumulating region 11 and the solution constricting region 12.

Besides, since the movable body 4 higher in temperature than the support 1 comes in contact with the organic solution 20, the evaporation of the solvent necessary for the crystallization of the solute in the organic solution 20 is accelerated. This shortens the time necessary for the crystallization of the solute, as compared with a case in which a solvent is naturally vaporized.

Therefore, it is possible to form the single-crystal organic thin film 30 rapidly while controlling the thickness and the size.

In particular, in order to form the single-crystal organic thin film 30, it is only necessary to move the movable body 4 (the temperature TM) while keeping it in contact with the organic solution 20, after the organic solution 20 is supplied to the one surface of the film-formation substrate 10 supported by the support 1 (the temperature TS). Therefore, a special environment such as a decompression environment is not necessary, and a special device is not necessary either and thus, it is possible to form the single-crystal organic thin film 30 easily.

Further, when the solution accumulating region 11 and the solution constricting region 12 are lyophilic with respect to the organic solution 20 (the lyophilic region 13), and other region is liquid-repellent with respect to the organic solution 20 (the liquid-repellent region 14), the organic solution 20 is readily fixed in a desired range (the lyophilic region 13) by using a difference in wettability. Therefore, the above-mentioned increase in supersaturation of the organic solution 20 occurs without fail and thus, it is possible to control the formation position of the organic thin film 30 precisely.

### [Modification]

It is to be noted that the planar shape of the solution accumulating region 11 and the solution constricting region 12 is freely modifiable, without being limited to the case illustrated in FIG. 2. Since the planar shape of the organic thin film 30 is determined based on the planar shape of the planar shape of the solution accumulating region 11 and the solution constricting region 12, the planar shape of the organic thin film 30 can be controlled according to the planar shape of the solution accumulating region 11 and the solution constricting region 12. Here, another example concerning the planar shape of the solution accumulating region 11 and the solution constricting region 12 is illustrated in FIG. 9.

In (A) to (D) of FIG. 9, the planar shape of the solution accumulating region 11 is changed to a diamond shape, a stepped shape, a circle shape, or a triangle shape. In (E) and (F) of FIG. 9, the solution accumulating region 11 is expanded in the moving direction of the movable body 4 (from the position S1 towards the position S2), in the examples illustrated in FIG. 2 and (A) of FIG. 9, respectively. In this case, the width of the solution accumulating region 11 may be constant as illustrated in (E) of FIG. 9, or the width of the solution accumulating region 11 may be changed as illustrated in (F) of FIG. 9. In (G) of FIG. 9, the liquid-repellent region 14 is provided inside the solution accumulating region 11 (the lyophilic region 13), in the example illustrated in (A) of FIG. 9. In this case, it is also possible to form the single-crystal organic thin film 30 in a manner similar to the case illustrated in FIG. 2, since the solution accumulating region 11 is provided. In (H) and (I) of FIG. 9, the width is continually decreased from the solution accumulating region 11 towards the solution constricting region 12, in the examples illustrated in FIG. 2 and (D) of FIG. 9, respectively. In this case, it is possible to form a substantially single crystal nucleus, because the formation range of the crystal nucleus is reduced to the smaller range in the organic solution 20.

A series of characteristics concerning the planar shape of the solution accumulating region 11 and the solution constricting region 12 described with reference to FIG. 2 and FIG. 9 may be freely combined. One example is that the liquid-repellent region 14 may be provided inside the solution accumulating region 11 (the lyophilic region 13) as illustrated in (G) of FIG. 9, in the example illustrated in (C) of FIG. 9 in place of (A) of FIG. 9. In addition, the solution accumulating region 11 may be expanded as illustrated in (E) and (F) of FIG. 9, in the example illustrated in (B) of FIG. 9 in place of FIG. 2.

It is to be noted that, as illustrated in (E) and (F) of FIG. 9, when the solution accumulating region 11 is expanded, the organic solution 20 is supplied to only a part of the solution accumulating region 11 and the solution constricting region 12. Then, the organic thin film 30 may be formed while the organic solution 20 is additionally supplied to the solution accumulating region 11 as necessary by using a solution pump. In this case, since the formation range of the organic thin film 30 is expanded according to the feed rate of the organic solution 20, it is possible to control the size (a plane size) of the organic thin film 30.

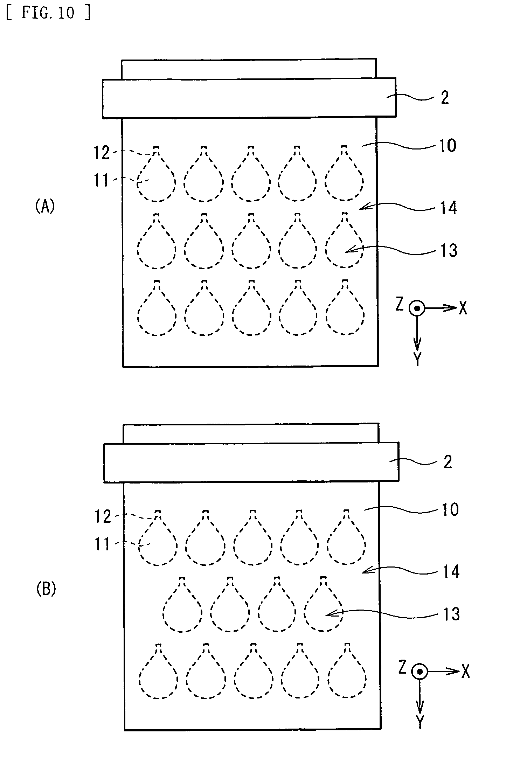

In addition, although only one set of the solution accumulating region 11 and the solution constricting region 12 is provided on the one surface of the film-formation substrate 10, a plurality of sets of the solution accumulating region 11 and the solution constricting region 12 may be provided as illustrated in FIG. 10 corresponding to FIG. 2. In this case, the way of arranging the plurality of sets of the solution accumulating region 11 and the solution constricting region 12 is not limited in particular. One example is that, as illustrated in (A) of FIG. 10, the plurality of sets of the solution accumulating region 11 and the solution constricting region 12 may be arranged so that respective lines agree with each other in terms of position in the moving direction of the movable body 4. Alternatively, as illustrated in (B) of FIG. 10, the plurality of sets of the solution accumulating region 11 and the solution constricting region 12 may be arranged so that the positions of respective lines in the moving direction of the movable body 4 are alternately displaced. In this case, since the organic thin film 30 is formed in the solution accumulating region 11 and the solution constricting region 12 in each of the sets, it is possible to form a plurality of the organic thin films 30 collectively. As a matter of course, the planar shape of the solution accumulating region 11 and the solution constricting region 12 in each of the plurality of sets is not limited to the planar shape illustrated in FIG. 2, and may be any of the planar shapes illustrated in FIG. 9, or more than two kinds of planar shapes may be mixed.

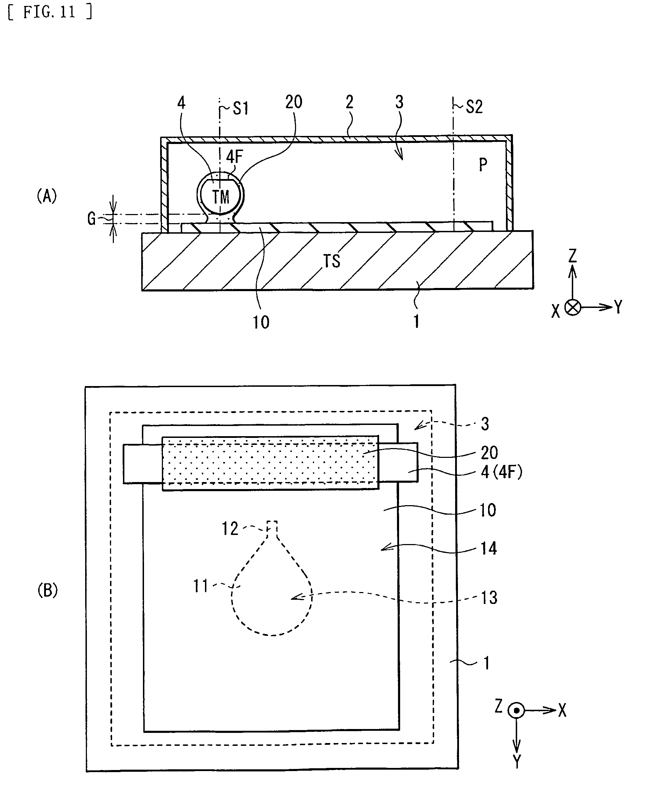

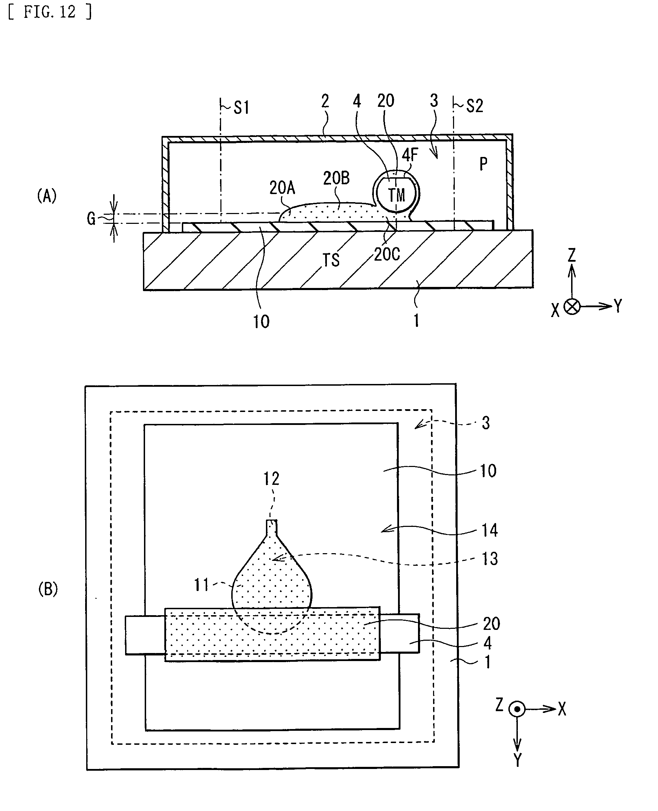

Further, instead of moving the movable body 4 after supplying the organic solution 20 to the one surface of the film-formation substrate 10 as illustrated in FIG. 3 to FIG. 7, the movable body 4 may be moved while the organic solution 20 is supplied to the one surface of the film-formation substrate 10, as illustrated in FIG. 11 and FIG. 12.

In this case, at first, as illustrated in FIG. 11, a flat section (a tapered section) 4F is formed at an upper part of the movable body 4 waiting in the position S 1, and a small amount of the organic solution 20 is supplied to the flat section 4F. This organic solution 20 reaches the one surface (the liquid-repellent region 14) of the film-formation substrate 10 along a side-surface part (a curved surface part) of the movable body 4, but is not allowed to be fixed in the liquid-repellent region 14.

After this, in a manner similar to the case described with reference to FIG. 3 to FIG. 7, the movable body 4 is moved from the position S1 to the position S2. In this case, since the organic solution 20 moves with the movable body 4 as illustrated in FIG. 12, the organic solution 20 is fixed in the lyophilic region 13 when the movable body 4 reaches the lyophilic region 13. Besides, in a process in which the movable body 4 moves while the organic solution 20 is fixed in the lyophilic region 13, the organic solution 20 accumulated on the flat section 4F of the movable body 4 is additionally supplied even when the organic solution 20 is consumed to be fixed in the lyophilic region 13. Therefore, when the movable body 4 moves from the position S1 to the position S2, the organic solution 20 is supplied to the lyophilic region 13 (the solution accumulating region 11 and the solution constricting region 12), in a manner similar to the case in which the movable body 4 is moved after the organic solution 20 is supplied to the one surface of the film-formation substrate 10.

In this case, the single-crystal organic thin film 30 is also formed by solution growth using the organic solution 20, since the functions similar to those in the case described with reference to FIG. 3 to FIG. 7 are achieved. Therefore, it is possible to form the single-crystal organic thin film 30 rapidly and easily while controlling the thickness and the size. In particular, when the movable body 4 is moved while the organic solution 20 is supplied, only a small amount of the organic solution 20 is necessary to fill the solution accumulating region 11 and the solution constricting region 12, and it is only necessary to supply the organic solution 20 to the flat section 4F of the movable body 4. Hence, it is possible to easily form the single-crystal organic thin film 30, by using a small amount of the organic solution 20.

### <2. Other Methods of Forming Organic Thin Films>

### <2-1. Solution-Temperature Controlling Type>

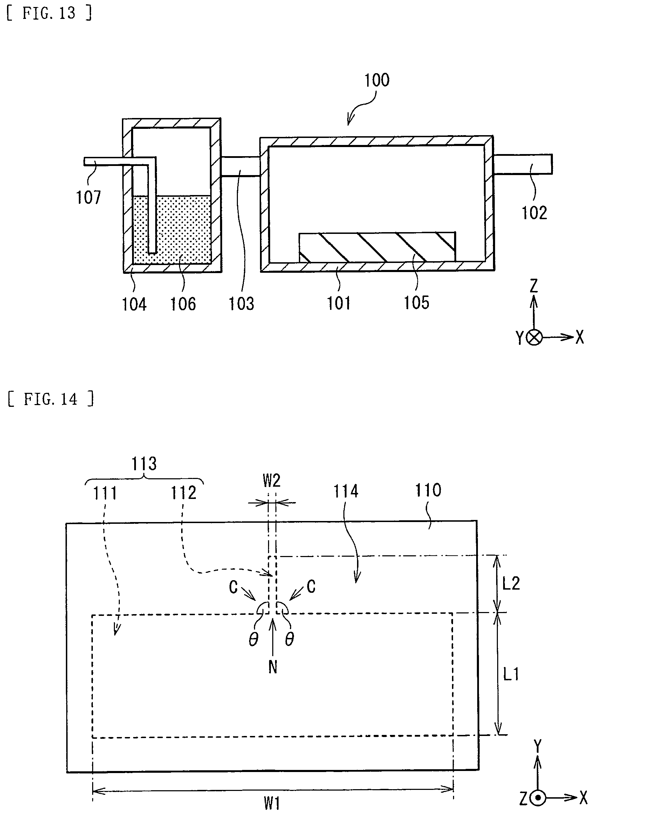

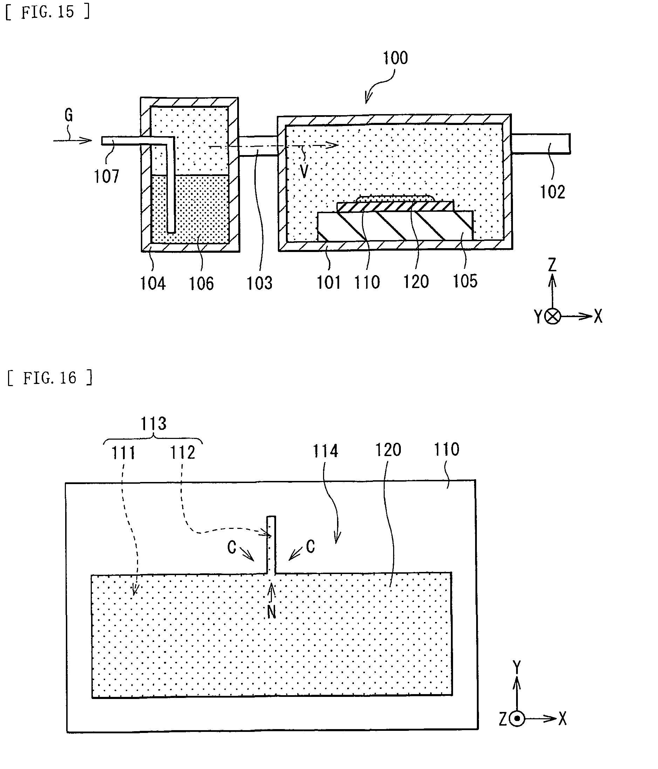

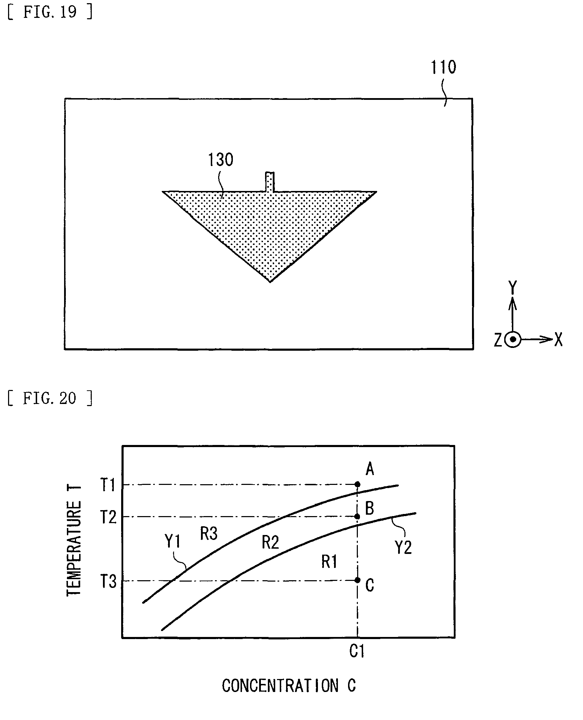

FIG. 13 to FIG. 20 are intended to explain a solution-temperature controlling type among other methods of forming an organic thin film in an embodiment of the technology. FIG. 13 and FIG. 14 depict a cross-sectional configuration of an apparatus (a film-formation apparatus 100) used in a method of forming an organic thin film and a plane configuration of a film-formation substrate 110, respectively. FIG. 15 to FIG. 19 each depict a cross-sectional configuration and a plane configuration, to explain a process of forming the organic thin film corresponding to FIG. 13 and FIG. 14. FIG. 20 depicts a solubility curve Y1 and a super-solubility curve Y2 concerning an organic solution 120 to explain formation conditions of the organic thin film, and a horizontal axis and a vertical axis indicate a concentration C and a temperature T, respectively.

The method of forming the organic thin film described here is a method of forming a single-crystal organic thin film 130 by solution growth through use of the organic solution 120. It is to be noted that the organic solution 120 contains a solvent and an organic material dissolved therein, and may contain materials other than those as necessary.

Before describing the method of forming the organic thin film, configurations of the film-formation apparatus 100 and the film-formation substrate 110 used for the formation method, as well as contents of the solubility curve Y1 and the super-solubility curve Y2 will be described below.

### [Configuration of Film-Formation Apparatus]

The film-formation apparatus 100 includes, for example, as illustrated in FIG. 13 and FIG. 15, a chamber 101 provided with an exhaust pipe 102, and a solvent tank 104 connected to the chamber 101 through a connecting pipe 103.

The chamber 101 houses a substrate holder 105, and is capable of being sealed in a state of being connected to the solvent tank 104. The substrate holder 105 supports the film-formation substrate 110, and is, for example, a susceptor capable of controlling a temperature. Thus, the temperature TS of the organic solution 120 is controlled according to the temperature of the film-formation substrate 110.

The solvent tank 104 stores a solvent (a co-solvent) 106 of the same type as that of the solvent in the organic solution 120, and the temperature of the co-solvent 106 is adjustable by an oil bath or the like not illustrated. Here, in order to distinguish the solvent stored in the solvent tank 104 and the solvent in the organic solution 120, the former solvent is referred to as the co-solvent 106. Gas G can be introduced into this co-solvent 106, through a gas introduction pipe 107 installed from the outside into the inside of the solvent tank 104, and the solvent tank 104 is capable of supplying steam V containing the co-solvent 106 to the chamber 101 through the connecting pipe 103. Thus, a pressure (a vapor pressure) P of the steam V in an environment surrounding of the organic solution 120 (the inside of the chamber 101) is controlled according to the temperature of the co-solvent 106. It is to be noted that the steam V supplied to the chamber 101 can be discharged to the outside as necessary, through the exhaust pipe 102.

### [Configuration of Film-Formation Substrate]

The film-formation substrate 110 is a substrate onto which the organic solution 120 is supplied and the organic thin film 130 is formed, and is, for example, a board made of glass, a plastic material, a metallic material, or the like, or a film made of a plastic material, a metallic material, or the like, or may be other than those. This film-formation substrate 110 may be a substrate in which various films in one layer or two or more layers are provided on the above-mentioned board, film, or the like.

The film-formation substrate 110 has, on a one surface on the side where the organic thin film 130 is formed, a solution accumulating region 111 to which the organic solution 120 is supplied, and a solution constricting region 112 connected thereto, as illustrated in FIG. 14.

The solution accumulating region 111 is a region intended to accumulate the organic solution 120 consumed to form the organic thin film 130, and the area thereof is determined by a width W1 and a length L1. It is preferable that the width W1 and the length L1 be large enough to secure the amount of the organic solution 120, and, for example, the width W1 = 1,000 µm to 10,000 µm and the length L1 = 100 µm to 800 µm. However, the width W1 and the length L 1 are freely modifiable.

The solution constricting region 112 is a region intended to constrict the organic solution 120 supplied to the solution accumulating region 111, and the area thereof is determined by a width W2 and a length L2. The width W2 of this solution constricting region 112 is smaller than the width W 1 of the solution accumulating region 111, and a corner section C in an inwardly convex shape is formed at a connection position N between the solution accumulating region 111 and the solution constricting region 112. It is preferable that the width W2 is sufficiently small to constrict the organic solution 120 which flows from the solution accumulating region 111 into the solution constricting region 112, and, for example, the width W2 = 5 µm to 30 µm and the length L2 = 5 µm to 200 µm. However, the width W2 and the length L2 are freely modifiable as long as the width W2 is smaller than the width W1.

The film-formation substrate 110 has the solution accumulating region 111 which is wide in width and the solution constricting region 112 which is narrow in width, so as to cause a difference in area of a liquid phase (the organic solution 120) contacting a vapor phase (the steam V). In the solution accumulating region 111 whose area contacting the vapor phase is a large (the width W1 is larger than the width W2), the solvent in the organic solution 120 easily evaporates. In contrast, in the solution constricting region 112 whose area contacting the vapor phase is small (the width W2 is smaller than the width W1), the solvent in the organic solution 120 is resistant to evaporation. This locally accelerates the evaporation of the solvent in proximity to the connection position N and thus, supersaturation of the organic solution 120 locally increases. In the technology, in order to form the organic thin film 130 by solution growth through use of the organic solution 120, the solute (the organic material) in the organic solution 120 is crystallized using the above-described local increase in the supersaturation. This mechanism of forming the organic thin film 130 will be described later in detail.

The nose shape of the corner section C is not limited in particular, but, above all, being acute is preferable so as to constrict the organic solution 120 reliably at the connection position N. In addition, an angle θ of the corner section C is not limited in particular, but, above all, a right angle is preferable for the same reason as that of the nose shape of the corner section C.

In particular, the film-formation substrate 110 has, for example, as illustrated in FIG. 14, a lyophilic region 113 and a liquid-repellent region 114, on the one surface, and it is preferable that the solution accumulating region 111 and the solution constricting region 112 described above be the lyophilic region 113. In this case, the solution accumulating region 111 and the solution constricting region 112 are lyophilic (the lyophilic region 113) with respect to the organic solution 120, whereas other region is liquid-repellent (the liquid-repellent region 114) with respect to the organic solution 120. Here, the number of the lyophilic regions 113 (the number of sets of the solution accumulating region 111 and the solution constricting region 112) is, for example, one (one set).

The lyophilic region 113 is a region that easily becomes wet with respect to the organic solution 120, and has a property of causing the organic solution 120 to be fixed onto the one surface of the film-formation substrate 110. On the other hand, the liquid-repellent region 114 is a region resistant to being wet with respect to the organic solution 120, and has a property of rejecting the organic solution 120 on the one surface of the film-formation substrate 110. The film-formation substrate 110 having the lyophilic region 113 and the liquid-repellent region 114 may be, for example, a substrate in which a liquid-repellent surface treatment or a liquid-repellent film formation treatment is applied to a lyophilic board or the like, or may be a substrate in which a lyophilic surface treatment or a lyophilic film formation treatment is applied to a liquid-repellent board or the like. In the former case, a region to which the surface treatment is applied becomes the liquid-repellent region 114, and other region becomes the lyophilic region 113. In the latter case, a region to which the surface treatment is applied becomes the lyophilic region 113, and other region becomes the liquid-repellent region 114.

The film-formation substrate 110 has the lyophilic region 113 and the liquid-repellent region 114, so as to fix the organic solution 120 in a desired region (the lyophilic region 113) by using a difference in wettability. A range in which the organic solution 120 is present is thereby precisely controlled. It is to be noted that the wettability (surface energy) of the lyophilic region 113 and that of the liquid-repellent region 114 may be different to the extent that the organic solution can be fixed to the lyophilic region 113.

### [Solubility Curve and Super-Solubility Curve]

The solubility curve Y1 and the super-solubility curve Y2 illustrated in FIG. 20 represent a solution property of the organic material. It is preferable that the solubility curve Y1 and the super-solubility curve Y2 be prepared (measured) in advance before forming the organic thin film 130, for an organic material to be used to form the organic thin film 130 and a solvent in which it is to be dissolved.

Ranges R1 to R3 each depict a state of the organic solution 120. The range R3 on a side higher in temperature than the solubility curve Y1 is the state in which a crystal dissolves (a solution state). The range R2 between the solubility curve Y1 and the super-solubility curve Y2 is the state in which crystal grows from a crystal nucleus (a crystal growth state) as the starting point. The range R1 on a side lower in temperature than the super-solubility curve Y2 is the state in which a crystal nucleus is formed (a crystal nucleation state). It is to be noted that, a point A to a point C each represent an example of a temperature condition in forming the organic thin film 130.

### [Process of Forming Organic Thin Film]

When the organic thin film 130 is formed, at first, the organic solution 120 (an arbitrary concentration C1: FIG. 20), the solubility curve Y1 and the super-solubility curve Y2 concerning the organic solution 120 (FIG. 20), and the film-formation substrate 110 having the solution accumulating region 111 and the solution constricting region 112 on the one surface (FIG. 14) are prepared.

The type of the solvent used to prepare the organic solution 120 is not limited in particular as long as it is a liquid in which an organic material serving as the solute can be dissolved, however, above all, an organic solvent in which many kinds of organic materials can be dissolved easily and stably while having superior volatility is preferable. In addition, the type of the organic material is freely selectable according to the quality of the organic thin film 130. On example is that the organic material is an organic semiconductor material in which, for instance, electrical properties (electron mobility and the like) change according to a crystal growth direction (a sequence direction of organic molecules).

Subsequently, as illustrated in FIG. 15 and FIG. 16, using the film-formation apparatus 100, the film-formation substrate 110 is fixed onto the substrate holder 105 in the chamber 101, and the co-solvent 106 which is of the same type as that of the solvent in the organic solution 120 is stored in the solvent tank 104.

Then, the organic solution 120 is supplied to the one surface (the solution accumulating region 111 and the solution constricting region 112 which form the lyophilic region 113) of the film-formation substrate 110. In this case, for example, the organic solution 120 is supplied to the solution accumulating region 111, and the organic solution 120 is caused to flow from the solution accumulating region 111 into the solution constricting region 112. Since the solution accumulating region 111 and the solution constricting region 112 are lyophilic (the lyophilic region 113) with respect to the organic solution 120, the organic solution 120 is so fixed as to fill the solution accumulating region 111 and the solution constricting region 112. The feed rate of the organic solution 120 may be any rate, as long as at least the solution accumulating region 111 and the solution constricting region 112 can be filled.

Subsequently, after the exhaust pipe 102 is closed and the film-formation apparatus 100 (the chamber 101 and the solvent tank 104) is sealed, the gas G such as nitrogen (N₂) is introduced from the gas introduction pipe 107 into the solvent tank 104, for example. This causes supply of the steam V containing the co-solvent 106 from the solvent tank 104 to the chamber 101 through the connecting pipe 103 and thus, the inside of the chamber 101 is in an environment of being filled with the steam V.

In this case, the temperature of the film-formation substrate 110 is set at T1 by using the substrate holder 105. Further, it is preferable to set the temperature of the co-solvent 106 at T1 by using an oil bath or the like. This causes the vapor pressure P in the chamber 101 to be a saturated steam pressure at the temperature T1 and thus, a solution layer (the organic solution 120) and the vapor phase (the steam V) reach equilibrium. This also applies to a liquid phase (the co-solvent 106) and the vapor phase (the steam V) in the solution tank 104.

The temperature T1 set here is, as illustrated in FIG. 20, a temperature positioned on the side (the range R3) higher in temperature than the solubility curve Y1, to be more specific, for example, a temperature corresponding to the point A. Thus, the temperature TS of the organic solution 120 also becomes T1, and therefore, the organic solution 120 is in the solution state. Afterwards, the temperature TS of the organic solution 120 and the like are set as appropriate by using the above-described substrate holder 105 and the like.

Subsequently, the temperature TS of the organic solution 120 is lowered from T1 to T2. In this case, it is preferable to lower the temperature of the co-solvent 106 from T1 to T2. Not only the temperature TS of the organic solution 120 but also the temperature of the co-solvent 106 are lowered together, so as to suppress an influence of the vapor pressure P on the evaporation of the solvent, by maintaining the state of equilibrium between the solution layer and the vapor phase, which remains the same afterwards.

The temperature T2 set here is, as illustrated in FIG. 20, a temperature located (in the range R2) between the solubility curve Y1 and the super-solubility curve Y2, to be more specific, for example, a temperature corresponding to the point B. This causes the organic solution 120 to be in the crystal growth state.

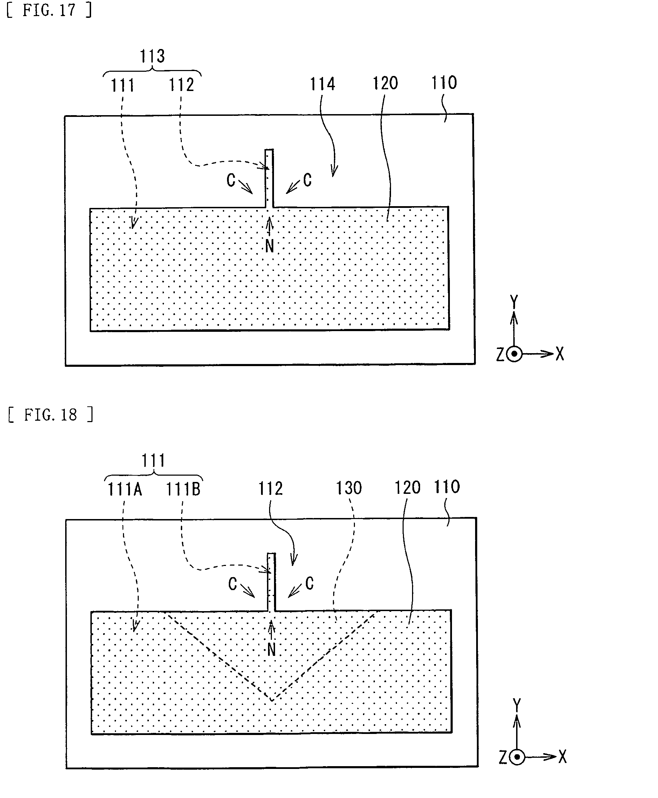

Here, a crystal nucleus has not yet been formed in the organic solution 120, and therefore, normally, neither the formation of the crystal nucleus nor the crystal growth should occur even when the organic solution 120 is in the crystal growth state. However, when the temperature TS becomes T2, a crystal nucleus is formed in the organic solution 120, and a crystal grows up from the crystal nucleus as the starting point, as illustrated in FIG. 17 and FIG. 18, for the following reason.

The organic solution 120 is present in the solution accumulating region 111 which is wide in width and the solution constricting region 112 which is narrow in width, and thus is constricted in the solution constricting region 112 as compared to the solution accumulating region 111. Therefore, a difference in area contacting the vapor phase (the steam V) occurs between the organic solution 120 existing in the solution accumulating region 111 and the organic solution 120 existing in the solution constricting region 112, as described above. For this reason, the solvent in the organic solution 120 easily evaporates in the solution accumulating region 111 in which the area contacting the vapor phase is large, whereas the solvent in the organic solution 120 is resistant to evaporation in the solution constricting region 112 in which the area contacting the vapor phase is small. A difference in evaporation rate occurs in response to this difference in the area contacting the vapor phase, and the evaporation of the solvent locally accelerates in proximity to the connection position N in the organic solution 120, and therefore, supersaturation of the organic solution 120 increases locally. Thus, in a region where the degree of supersaturation has increased locally, the organic solution 120 is in a state similar to the crystal nucleation state on the side (the range R1) lower in temperature than the super-solubility curve Y2, and therefore, the solute in the organic solution 120 crystallizes. As a result, a crystal nucleus is formed in a small range (in proximity to the connection position N) in the organic solution 120. In addition, due to a diffusion phenomenon of the solute in the organic solution 120, a crystal grows from the crystal nucleus as the starting point, while being supplied with the solute from the organic solution 120. The single-crystal organic thin film 130 is thereby formed. In this case, a substantially single crystal nucleus is formed when the width W2 of the solution constricting region 112 is sufficiently narrow.

After this, the temperature TS of the organic solution 120 may be decreased from T2 to a temperature lower than that, as necessary. In this case, it is preferable to lower the temperature of the co-solvent 106 similarly. A target temperature in this case is not limited in particular as long as it is a temperature below the temperature T2, but is, for example, a temperature positioned on the side lower in temperature than the super-solubility curve Y2 (the range R1), to be more specific, T3 corresponding to the point C, as illustrated in FIG. 20. When the temperature TS is lowered below T2, a strong driving force accelerating the crystal growth is generated, and therefore, the organic thin film 130 grows to a great extent.

Finally, the organic thin film 130 is obtained as illustrated in FIG. 19, by removing the organic solution 120 from the one surface of the film-formation substrate 110, through absorption or the like, as necessary.

Here, for example, as illustrated in FIG. 19, the organic thin film 130 having the planar shape of a substantially triangle is formed. However, depending on conditions such as retentivity (the presence or absence of a flow and the degree of a flow) of the organic solution 120, the organic thin film 130 having other planar shape such as a rectangle may be formed. In this case, the organic thin film 130 may be patterned to have a desired planar shape, by using etching or the like, as necessary.

It is to be noted that, between the configuration of the solution accumulating region 111 and the solution constricting region 112 and the configuration of the organic thin film 130, there is a relationship as follows.

First of all, the connection position N between the solution accumulating region 111 and the solution constricting region 112 determines a position where the degree of supersaturation of the organic solution 120 locally increases, and thus determines a position where the crystal nucleus is formed. Therefore, it is possible to control a crystal-growth starting position and a formation position of the organic thin film 130, according to the connection position N.

Secondly, when the crystal grows from the crystal nucleus as the starting point, the length L 1 of the solution accumulating region 111 determines an amount of the organic solution 120 that makes it possible to keep supplying the solute for continuous progress of the crystal growth. Therefore, it is possible to control the size (the plane size) of the organic thin film 130, according to the length L1.

Thirdly, the width W2 of the solution constricting region 112 affects the formation range and the number of crystal nuclei. When the width W2 is sufficiently small, the formation range of the crystal nuclei is reduced to an extremely small range and thus, a single crystal nucleus is easily formed. It is to be noted that, conceivably, when the width W2 is large, a crystal nucleus is formed at each of the corner sections C and thus, a crystal grows from each crystal nucleus. Therefore, even when the width W2 is large, the single-crystal organic thin film 130 should be formed for each of the corner sections C, in a manner similar to the case in which the width W2 is sufficiently small. However, in the case in which the crystal nucleus is formed for each of the corner sections C, the organic thin films 130 may collide with each other during the crystal growth when the width W2 is too small, and therefore, it is preferable that the width W2 be sufficiently large so as to avoid the collision.

Fourthly, the amount of growth of a crystal in a thickness direction depends on the feed rate of the solute supplied from the organic solution 120 in a growth process of that crystal. In other words, when the evaporation rate of the solvent rises, the amount of the solute consumed per unit time by a crystal growth increases, and therefore, the thickness of the organic thin film 130 becomes large. On the other hand, the evaporation rate of the solvent drops, the amount of the solute consumed per unit time by a crystal growth decreases, and therefore, the thickness of the organic thin film 130 becomes small. This difference in feed rate of the solute should be determined by a difference in evaporation rate (an area contacting the vapor phase) of the solvent between the solution accumulating region 111 and the solution constricting region 112. Therefore, it is possible to control the thickness of the organic thin film 130, according to the widths W1 and W2.

### [Functions and Effects of Method of Forming Organic Thin Film]

In this method of forming the organic thin film (the solution-temperature controlling type), the temperature TS of the organic solution 120 is lowered from T1 to T2, after the organic solution 120 is supplied to the solution accumulating region 111 which is wide in width and the solution constricting region 112 which is narrow in width so that the temperature TS becomes T1 and the vapor pressure P becomes the saturated steam pressure at T1. This T1 is a temperature positioned on the side (the range R3) higher in temperature than the solubility curve Y1, and T2 is a temperature positioned (in the range R2) between the solubility curve Y1 and the super-solubility curve Y2.

In this case, as described with reference to FIG. 13 to FIG. 20, the degree of supersaturation of the organic solution 120 rises locally in proximity to the connection position N between the solution accumulating region 111 and the solution constricting region 112, due to a decrease in the temperature TS of the organic solution 120. As a result, the crystal nucleus is formed in the small range in the organic solution 120, and the crystal grows from the crystal nucleus as the starting point, and thus, the single-crystal organic thin film 130 in which organic molecules are arranged regularly is formed. Therefore, it is possible to form the single-crystal organic thin film 130, by controlling the crystal-nucleus formation position and the crystal growth direction.

In particular, in order to form the single-crystal organic thin film 130, it is only necessary to change the temperature TS of the organic solution 120, after the organic solution 120 is supplied to the solution accumulating region 111 and the solution constricting region 112 in the environment where the vapor pressure P is the saturated steam pressure. Therefore, a special environment such as a decompression environment is not necessary, and a special device is not necessary either and thus, it is possible to form the single-crystal organic thin film 130 easily.

In addition, when the temperature TS is lowered below T2, a strong driving force accelerating the progress of the crystal growth is generated, and thus, it is possible to increase the plane size of the organic thin film 130.

Moreover, when the solution accumulating region 111 and the solution constricting region 112 are lyophilic with respect to the organic solution 120 (the lyophilic region 113), and other region is liquid-repellent with respect to the organic solution 120 (the liquid-repellent region 114), the organic solution 120 is readily fixed in a desired range (the lyophilic region 113) by using a difference in wettability. Therefore, the above-described increase in supersaturation of the organic solution 120 occurs without fail and thus, it is possible to control the formation position of the organic thin film 130 precisely.

### [Modification]

It is to be noted that the solvent tank 104 is connected to the chamber 101 through the connecting pipe 103, but is not necessarily limited to this. When the space in the chamber 101 is small, the solvent tank 104 may be provided separately from the chamber 101 and the steam V may be supplied to the chamber 101 from the outside, as described above. In contrast, when the space in the chamber 101 is large, for example, instead of connecting the solvent tank 104 to the chamber 101, a container such as a beaker containing the co-solvent 106 may be placed on the substrate holder 105, together with the film-formation substrate 110. In this case, it is possible to control the temperature TS of the organic solution 120 and the temperature of the co-solvent 106 together, by using the substrate holder 105.

Further, in FIG. 14, only one set of the solution accumulating region 111 and the solution constricting region 112 is provided on the one surface of the film-formation substrate 110, but a plurality of sets of the solution accumulating region 111 and the solution constricting region 112 may be provided. In this case, the way of arranging the plurality of sets of the solution accumulating region 111 and the solution constricting region 112 is freely determined.

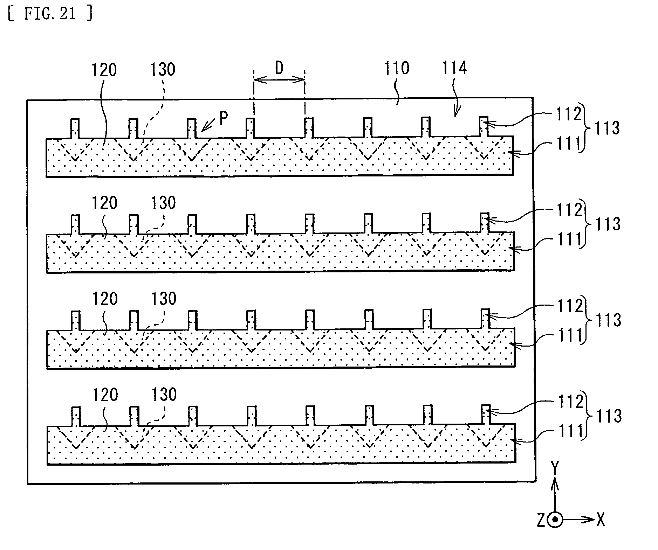

One example is that, as illustrated in FIG. 21, of the plurality of sets of the solution accumulating region 111 and the solution constricting region 112, a region in which the solution accumulating regions 111 next to each other are connected is formed, and a plurality of connection regions may be arranged in a direction (a Y-axis direction) intersecting a connection direction (an X-axis direction) in which the solution accumulating regions 111 are connected. The number of connections and the number of arrays in this case are arbitrary. In each of the connection regions, a plurality of the solution constricting regions 112 is connected to the one solution accumulating region 111. However, only one connection region may be used.

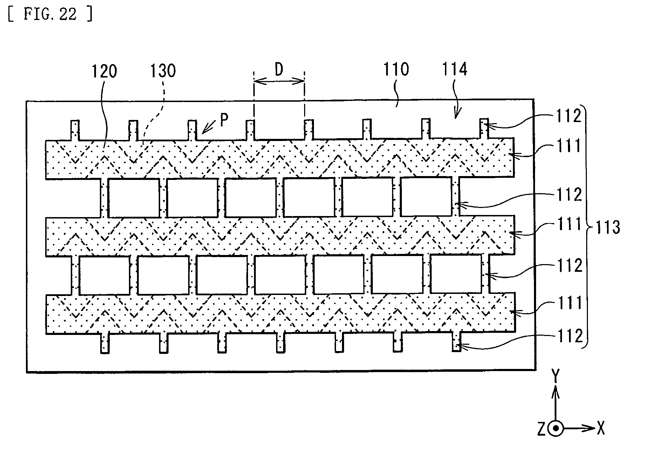

Alternatively, as illustrated in FIG. 22, when the plurality of connection regions are arranged (FIG. 21), the solution accumulating region 111 and the solution constricting region 112 next to each other in the arrangement direction thereof may be connected, and the position of the solution constricting region 112 may be displaced in the same direction. The position of the solution constricting region 112 is displaced to avoid collision of the organic thin films 130 against each other. However, the position of the solution constricting region 112 may not be displaced, when the length L1 (see FIG. 14) of the solution accumulating region 111 is sufficiently large to the extent that the organic thin films 130 do not collide with each other.

In either of the respective examples illustrated in FIG. 21 and FIG. 22, a space D between the solution constricting regions 112 next to each other is not limited in particular, but is, for example, 0.1 mm to 1 mm. When the plurality of sets of the solution accumulating region 111 and the solution constricting region 112 are provided, it is possible to form a plurality of the organic thin films 130 collectively, since the organic thin film 130 is formed for each part in proximity to the connection position N.

### <2-2. Vapor-Pressure Controlling Type>

Next, among other methods of forming an organic thin film in an embodiment of the technology, a vapor-pressure controlling type will be described.

A method of forming an organic thin film which will be described here is based on procedures similar to those of the solution-temperature controlling type, except that a procedure of forming a crystal nucleus and causing a crystal to grow from the crystal nucleus as a starting point is different. The method of forming the organic thin film of the vapor-pressure controlling type will be described below, while citing the drawings (FIG. 13 to FIG. 20) described in the solution-temperature controlling type, whenever necessary.

### [Process of Forming Organic Thin Film]

When an organic thin film is formed, the organic solution 120, the solubility curve Y1 as well as the super-solubility curve Y2 (FIG. 20), and the film-formation substrate 110 (FIG. 14) are prepared in a manner similar to the solution-temperature controlling type. After this, as illustrated in FIG. 15 and FIG. 16, the organic solution 120 (the arbitrary concentration C1: FIG. 20) is supplied to the one surface (the solution accumulating region 111 and the solution constricting region 112) of the film-formation substrate 110, in an environment in which the inside of the chamber 101 is filled with the steam V.

In this case, the temperature of the film-formation substrate 110 and the temperature of the co-solvent 106 are set at T2, and the vapor pressure P at the temperature T2 is set at the saturated steam pressure, thereby causing the liquid phase and the vapor phase reach equilibrium.

The temperature T2 set here is, as illustrated in FIG. 20, a temperature positioned (in the range R2) between the solubility curve Y1 and the super-solubility curve Y2, and is, to be more specific, for example, a temperature corresponding to the point B. Thus, the organic solution 120 is in the crystal growth state.

Subsequently, the vapor pressure P is lowered while the temperature TS of the organic solution 120 is maintained at T2. In this case, for example, the steam V in the chamber 101 may be discharged to the outside, by slightly opening the exhaust pipe 102. The discharge amount (a target vapor pressure) of the steam V in this case may be any amount. However, it is preferable not to too suddenly lower the vapor pressure P, so as to prevent a crystal nucleus from being formed in the organic solution 120 at random.

Here, a crystal nucleus has not yet been formed in the organic solution 120, and therefore, normally, neither the formation of the crystal nucleus nor the crystal growth should occur even when the vapor pressure P is lowered. However, as illustrated in FIG. 17 and FIG. 18, when the vapor pressure P drops, a crystal nucleus is formed in the organic solution 120 and a crystal grows from the crystal nucleus as the starting point, for the following reason.

When the vapor pressure P drops, the equilibrium between the liquid phase the vapor phase collapses and thus, the solvent in the organic solution 120 easily evaporates. In this case, since the organic solution 120 is present in the solution accumulating region 111 which is wide in width and the solution constricting region 112 which is narrow in width, the degree of supersaturation of the organic solution 120 locally rises in proximity to the connection position N, in a manner similar to the solution-temperature controlling type. Therefore, a crystal nucleus is formed in a small range in the organic solution 120, and a crystal grows from the crystal nucleus as the starting point, and thus, the single-crystal organic thin film 130 is formed.

Finally, in a manner similar to the solution-temperature controlling type, the organic thin film 130 is obtained as illustrated in FIG. 19, by removing the organic solution 120 from the one surface of substrate 110 as necessary.

### [Functions and Effects of Method of Forming Organic Thin Film]

In this method of forming the organic thin film (the vapor-pressure controlling type), the vapor pressure P is lowered, after the organic solution 120 is supplied to the solution accumulating region 111 which is wide in width and the solution constricting region 112 which is narrow in width so that the temperature TS of the organic solution 120 becomes T2 and the vapor pressure P becomes the saturated steam pressure at T2. This T2 is a temperature positioned (in the range R2) between the solubility curve Y1 and the super-solubility curve Y2.

In this case, as described with reference to FIG. 13 to FIG. 20, due to a drop in the vapor pressure P, the supersaturation of the organic solution 120 locally rises in proximity to the connection position N between the solution accumulating region 111 and the solution constricting region 112, in a manner similar to the solution-temperature controlling type. As a result, the crystal nucleus is formed in the small range in the organic solution 120, and the crystal grows from the crystal nucleus as the starting point, and thus, the single-crystal organic thin film 130 is formed. Therefore, it is possible to form the single-crystal organic thin film 130 by controlling the crystal-nucleus formation position and the crystal growth direction.

In particular, in the vapor-pressure controlling type, it is possible to form the single-crystal organic thin film 130 in a shorter time than that in the solution-temperature controlling type. This is because, when the vapor pressure P is lowered, the solvent tends to more remarkably evaporate than that in the case in which the temperature TS of the organic solution 120 is lowered, and therefore, the degree of supersaturation of the organic solution 120 is likely to rise in a short time. It is to be noted that, except those described above, functions, effects, and modifications of the vapor-pressure controlling type are similar to those of the solution-temperature controlling type.

### <2. Method of Manufacturing Organic Device>

Next, an application example of the above-described series of methods of forming organic thin films will be described.

The method of forming the organic thin film is applicable to various methods of manufacturing organic devices using organic thin films. Here, a method of manufacturing of an organic thin-film transistor (TFT), in which an organic thin film formed using an organic semiconductor material is utilized as a channel layer, will be described as an application example of the method of forming the organic thin film.

### [Configuration of Organic TFT]

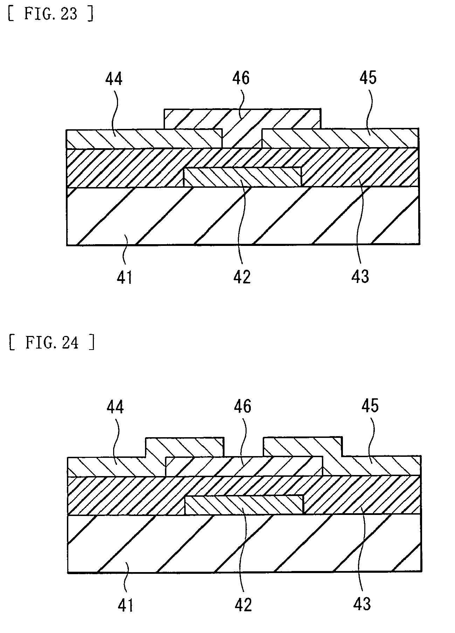

FIG. 23 depicts a cross-sectional configuration of an organic TFT manufactured using the method of forming the organic thin film. This organic TFT is, for example, a TFT in which a gate electrode 42, a gate insulating layer 43, a source electrode 44 as well as a drain electrode 45, and a channel layer 46 are laminated in this order on a substrate 41. This organic TFT is of a bottom-gate bottom-contact type, in which the gate electrode 42 is positioned below the channel layer 46 (on a side closer to the substrate 41), and the source electrode 44 and the drain electrode 45 overlap a lower side of the channel layer 46.

The substrate 41 is, for example, a board or a film similar to the film-formation substrate 10 described above.

The gate electrode 42 is, for example, formed of tungsten (W), tantalum (Ta), molybdenum (Mo), aluminum, chromium (Cr), titanium (Ti), copper (Cu), nickel, a compound of them, an alloy of them, or the like, on the substrate 41.

The gate insulating layer 43 covers the gate electrode 42 and the substrate 41 therearound, and is formed of, for example, an inorganic insulating material or an organic insulating polymer material. The inorganic insulating material is, for example, silicon oxide (SiO₂) or silicon nitride (Si₃N₄). The organic insulating polymer material is, for example, polyvinyl phenol, polymethyl methacrylate, polyimide, fluororesin, or the like.

The source electrode 44 and the drain electrode 45 are separated from each other on the gate insulating layer 43, and formed of, for example, an inorganic conductive material or an organic conductive material. The inorganic conductive material is, for example, gold (Au), platinum (Pt), palladium (Pd), silver (Ag), tungsten (W), tantalum (Ta), molybdenum (Mo), aluminum (Al), chromium (Cr), titanium (Ti), copper (Cu), nickel (Ni), indium (In), tin (Sn), manganese (Mn), ruthenium (Ru), rhodium (Rh), rubidium (Rb), a compound of them, an alloy of them, or the like. The organic conductive material is, for example, polyethylenedioxythiophene-polystyrene sulfonate (PEDOT-PSS), tetrathiafulvalene-7,7,8,8-tetracyanoquinodimethane (TTF-TCNQ), or the like.

The channel layer 46 is an organic thin film formed using the method of forming the organic thin film, and formed on the gate insulating layer 42, the source electrode 44, and the drain electrode 45. This channel layer 46 is, for example, formed of the following organic semiconductor materials. (1) Polypyrrole and derivatives thereof, (2) polythiophene and derivatives thereof, (3) isothianaphthenes such as polyisothianaphthene, (4) thienylenevinylenes such as polythienylenevinylene, (5) poly(p-phenylene vinylenes) such as poly(p-phenylene vinylene), (6) polyaniline and derivatives thereof, (7) polyacetylenes, (8) polydiacetylenes, (9) polyazulenes, or (10) polypyrenes. (11) Polycarbazoles, (12) polyselenophenes, (13) polyfurans, (14) poly(p-phenylenes), (15) polyindoles, (16) polypyridazines, (17) acenes such as naphthacene, pentacene, hexacene, heptacene, dibenzopentacene, tetrabenzopentacene, pyrene, dibenzopyrene, chrysene, perylene, coronene, terylene, ovalene, quaterrylene, and circumanthracene, (18) derivatives in which an atom such as nitrogen (N), sulfur (S), and oxygen (O), or a functional group such as a carbonyl group substitutes for a part of carbon of acenes, for example, triphenodioxazine, triphenodithiazine, hexacene-6,15-quinone, and the like, (19) polymer materials and polycyclic condensation products such as polyvinylcarbazole, polyphenylene sulfide, and polyvinylene sulphide, or (20) oligomers having the same repeating unit as those of these polymer materials. (21) Metallophthalocyanines, (22) tetrathiafulvalene and derivatives thereof, (23) tetrathiapentalene and derivatives thereof, (24) naphthalene-1,4,5,8-tetracarboxylic acid diimide, N,N'-bis(4-trifluoromethylbenzyl) naphthalene-1,4,5,8-tetracarboxylic acid diimide, N,N'-bis(1H,1H-perfluorooctyl), N,N'-bis(1H,1H-perfluorobutyl), and N,N'-dioctylnaphthalene-1,4,5,8-tetracarboxylic acid diimide derivatives, (25) naphthalenetetracarboxylic acid diimides such as naphthalene-2,3,6,7-tetracarboxylic acid diimide, (26) condensed ring tetracarboxylic acid diimide represented by anthracene tetracarboxylic acid diimides such as anthracene-2,3,6,7- tetracarboxylic acid diimide, (27) fullerenes such as C₆₀, C₇₀, C₇₆, C₇₈, and C₈₄, (28) a carbon nanotube such as single wall nanotube (SWNT), and (29) a pigment such as merocyanine dye and hemicyanine dye.

### [Method of Manufacturing Organic TFT]

When an organic TFT is manufactured, first, the gate electrode 42 is formed by patterning on one surface of the substrate 41. In this case, for example, after an electrode layer (not illustrated) is formed by depositing a material of the gate electrode 42, so as to cover the surface of the substrate 41 by using a vapor growth method or the like, the electrode layer is patterned using photolithography, etching, or the like. The vapor growth method is, for example, sputtering, deposition, chemical vapor deposition (CVD), or the like. Etching is, for example, dry etching such as ion milling and reactive ion etching (RIE), or wet etching. It is to be noted that, in a patterning process, after a photoresist film is formed by applying a photoresist to a surface of the electrode layer and the photoresist film is patterned using photolithography, the electrode layer is etched using the photoresist film as a mask.

Next, using a vapor growth method or the like, the gate insulating layer 43 is so formed as to cover the gate electrode 42 and the neighboring substrate 41.

Subsequently, the source electrode 44 and the drain electrode 45 are formed on the gate insulating layer 43 by patterning. In this case, for example, after an electrode layer (not illustrated) is formed by depositing a material of the source electrode 44 and the drain electrode 45 so as to cover a surface of the gate insulating layer 43, the electrode layer is patterned. It is to be noted that a formation method and a patterning method of the electrode layer are similar to those in the formation of the gate electrode 42.

Finally, the channel layer 46 which is an organic thin film is formed on the gate insulating layer 43, the source electrode 44, and the drain electrode 45, by using the organic thin film forming apparatus and the method of forming the organic thin film described above. In this case, a surface treatment (an optional film formation treatment and the like) may be applied as necessary to form the lyophilic region 113 or the liquid-repellent region 114 (FIG. 14). In the channel layer 46 formed by this method of forming the organic thin film, electrical properties (e.g., electron mobility) change according to a crystal growth direction. For this reason, when the channel layer 46 is formed, it is preferable to set a direction of forming the channel layer 46 so as to obtain desired electrical properties according to a positional relationship between the source electrode 44 and the drain electrode 45. The organic TFT is thereby completed.

### [Functions and Effects of Method of Manufacturing Organic TFT]

In this method of manufacturing the organic TFT, the channel layer 46 is formed using the organic thin film forming apparatus and the method of forming the organic thin film described above and thus, the thickness and the size of the channel layer 46 are controlled, and the channel layer 46 is formed rapidly and easily. Therefore, it is possible to manufacture the organic TFT rapidly and easily. Besides, the single-crystal channel layer 46 is formed while the crystal-nucleus formation position and the crystal growth direction are controlled. Therefore, it is possible to improve the electrical properties (electron mobility and the like) of the channel layer 46. Functions and effects are otherwise similar to those of the method of forming the organic thin film.

### [Modifications]

The organic TFT may be, for example, of a bottom-gate top-contact type, in which the source electrode 44 and the drain electrode 45 overlap an upper side of the channel layer 46, as illustrated in FIG. 24 corresponding to FIG. 23. In this case, the organic TFT is a TFT in which the gate electrode 42, the gate insulating layer 43, the channel layer 46, and the source electrode 44 as well as the drain electrode 45 are laminated in this order on the substrate 41. This organic TFT of the top-contact type is manufactured by the same procedure as that of the organic TFT of the bottom-contact type, except that the source electrode 44 and the drain electrode 45 are formed after the channel layer 46 is formed. Since the single-crystal channel layer 46 is formed, it is possible to improve performance of the organic TFT in this case as well. In particular, in the case of manufacturing the organic TFT of the top-contact type, the source electrode 44 and the drain electrode 45 are not yet formed at the time when the channel layer 46 is formed and therefore, it is possible to form the channel layer 46 readily and precisely on the flat gate insulating layer 43 as the surface of the gate insulating layer 43 is flat.

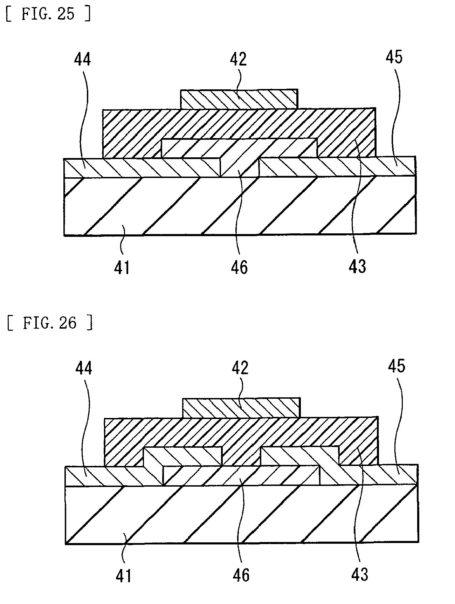

Further, the organic TFT may be, for example, of a top-gate type in which the gate electrode 42 is positioned above the channel layer 46 (on a side away from the substrate 41), as illustrated in FIG. 25 and FIG. 26 corresponding to FIG. 23. The organic TFT of a top-gate bottom-contact type is, as illustrated in FIG. 25, a TFT in which the source electrode 44 as well as the drain electrode 45, the channel layer 46, the gate insulating layer 43, and the gate electrode 42 are laminated in this order on the substrate 41. Furthermore, an organic TFT of a top-gate top-contact type is, as illustrated in FIG. 26, a TFT in which the channel layer 46, the source electrode 44 as well as the drain electrode 45, the gate insulating layer 43, and the gate electrode 42 are laminated in this order on the substrate 41. It is possible to obtain similar effects in these cases as well.

### Example

Next, an Example of the technology will be described in detail.

Using the film-formation apparatus 100 illustrated in FIG. 13 and the film-formation substrate 110 illustrated in FIG. 21 (the number of the solution constricting regions 112 = 3, the number of the connection regions = 1), a test of forming the organic thin film 130 was carried out through use of the method of forming the solution-temperature controlling type. In this film-formation substrate 110, an amorphous fluororesin film (CYTOP manufactured by Asahi Glass Co., Ltd.) was partially formed on an organic insulating film (a polyvinylpyrrolidone film) that was provided to cover one surface of a silicon board, and therefore the lyophilic region 113 (the solution accumulating region 111 and the solution constricting region 112) and the liquid-repellent region 114 were formed. The dimension of each part in the film-formation substrate 110 was as follows; the width W1 = 6,500 µm and the length L1 = 400 µm of the solution accumulating region 111, and the width W2 = 10 µm, the length L2 = 100 µm, and the interval D = 1 mm of the solution constricting region 112. In a case of preparing the organic solution 120, an organic semiconductor material represented by an expression (1) was used as a solute, tetralin was used as a solvent, and the concentration of the solute was 0.5 wt%. The co-solvent 106 was tetralin which was the same as the solvent in the organic solvent 120.

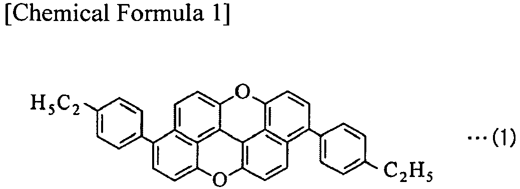

By the procedure of the solution-temperature controlling type, in the inside of the chamber 101 filled with the steam V (containing the nitrogen gas) of the co-solvent 106, the organic solution 120 was supplied to the solution accumulating region 111 and the solution constricting region 112 and then, the temperature TS of the organic solution 120 was changed. In this case, it was assumed that the temperature T1 = 25°C, the temperature T2 = 19°C, and the temperature T3 = 17°C.

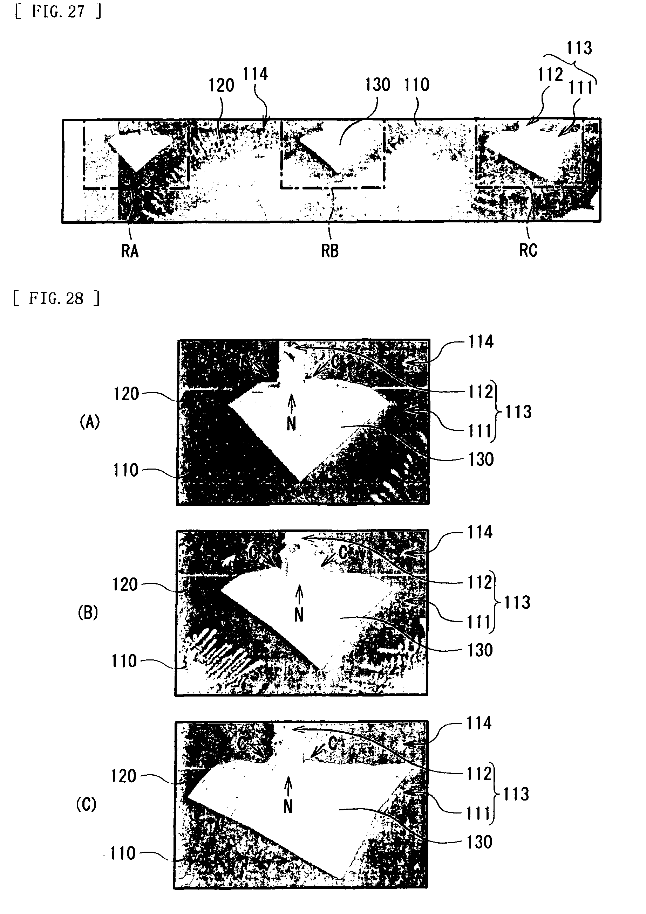

By observing the surface of the film-formation substrate 110 using an optical microscope after being left standing upon lowering the temperature TS to T3, results illustrated in FIG. 27 and FIG. 28 were obtained. FIG. 27 and FIG. 28 are optical photomicrographs showing experimental results concerning the method of forming the organic thin film 130, and in (A) to (C) of FIG. 28, ranges RA to RC illustrated in FIG. 27 are enlarged respectively.

As illustrated in FIG. 27 and FIG. 28, the organic thin film 130 having a planar shape of a substantially triangle was formed in proximity to the connection position N, for each of the connection positions N. By analyzing the organic thin film 130 using X-ray diffractometry, the organic thin film 130 was confirmed to be a single crystal.

The technology has been described above with reference to the embodiment, but the technology may be variously modified without being limited to aspects described in the embodiment. For example, the type of the organic material used in the method of forming the organic thin film of the technology is not limited to the organic semiconductor materials, and may be other types of materials. In addition, the method of forming the organic thin film of the technology may be applied to a method of manufacturing other organic device than the organic TFT. An example of such other organic device is an optical device using an organic thin film as a polarizing filter. In this optical device, a polarization direction changes according to a crystal growth direction (an orientation direction).

## Claims

1. A method of forming an organic thin film, the method comprising:
supplying an organic solution containing a solvent and an organic material dissolved therein to a solution accumulating region and a solution constricting region connected thereto on one surface of a film-formation substrate supported by a support controllable in temperature;
moving a movable body along a surface of the support while bringing the movable body in contact with the organic solution, the movable body being disposed opposite the support to be spaced apart from the film-formation substrate, and being controllable in temperature independently of the support;
setting a width of the solution constricting region to be smaller than a width of the solution accumulating region, and arranging the solution constricting region behind the solution accumulating region in a moving direction of the movable body; and
setting the temperature of the support at a temperature between a solubility curve (concentration versus temperature) and a super-solubility curve (concentration versus temperature) concerning the organic solution, and setting the temperature of the movable body at a temperature on a side higher in temperature than the solubility curve.

2. The method of forming the organic thin film according to claim 1, wherein the solution accumulating region and the solution constricting region are lyophilic with respect to the organic solution, and other region is liquid-repellent with respect to the organic solution.

3. The method of forming the organic thin film according to claim 1, wherein a vapor pressure in an environment surrounding the organic solution is set at a saturated vapor pressure at the temperature of the support.

4. The method of forming the organic thin film according to claim 1, wherein the organic thin film is a single crystal.

5. The method of forming the organic thin film according to claim 1, wherein the organic material is an organic semiconductor material.

6. An organic thin film forming apparatus, the apparatus comprising:
a film-formation substrate;
a support supporting the film-formation substrate and being controllable in temperature; and
a movable body disposed opposite the support to be spaced apart from the film-formation substrate, and the movable body being movable along a surface of the support and controllable in temperature independently of the support,
wherein the film-formation substrate has, on one surface, a solution accumulating region and a solution constricting region connected thereto, the solution accumulating region and the solution constricting region being supplied with an organic solution containing a solvent and an organic material dissolved therein,
a width of the solution constricting region is smaller than a width of the solution accumulating region, and the solution constricting region is arranged behind the solution accumulating region in a moving direction of the movable body, and
the movable body moves while being in contact with the organic solution supplied to the solution accumulating region and the solution constricting region.

7. The organic thin film forming apparatus according to claim 6, wherein the temperature of the support is set at a temperature between a solubility curve (concentration versus temperature) and a super-solubility curve (concentration versus temperature) concerning the organic solution, and the temperature of the movable body is set at a temperature on a side higher in temperature than the solubility curve.

8. The organic thin film forming apparatus according to claim 6, wherein the solution accumulating region and the solution constricting region are lyophilic with respect to the organic solution, and other region is liquid-repellent with respect to the organic solution.

9. The organic thin film forming apparatus according to claim 7, wherein a vapor pressure in an environment surrounding the organic solution is a saturated vapor pressure at the temperature of the support.

10. A method of manufacturing an organic device, the method, in order to manufacture an organic device using an organic thin film, comprising:
supplying an organic solution containing a solvent and an organic material dissolved therein to a solution accumulating region and a solution constricting region connected thereto on one surface of a film-formation substrate supported by a support controllable in temperature;
moving a movable body along a surface of the support while bringing the movable body in contact with the organic solution, the movable body being disposed opposite the support to be spaced apart from the film-formation substrate, and being controllable in temperature independently of the support;
setting a width of the solution constricting region to be smaller than a width of the solution accumulating region, and arranging the solution constricting region behind the solution accumulating region in a moving direction of the movable body; and
setting the temperature of the support at a temperature between a solubility curve (concentration versus temperature) and a super-solubility curve (concentration versus temperature), and setting the temperature of the movable body at a temperature on a side higher in temperature than the solubility curve.

11. A method of forming an organic thin film, the method comprising:
(1) preparing an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region connected thereto on one surface, the solution constricting region having a width smaller than a width of the solution accumulating region;
(2) supplying the organic solution to the solution accumulating region and the solution constricting region to allow a temperature TS of the organic solution to be a temperature T1 positioned on a side higher in temperature than the solubility curve, and a vapor pressure P in an environment surrounding the organic solution to be a saturated vapor pressure at the temperature T1; and
(3) lowering the temperature TS from the temperature T1 to a temperature T2 positioned between the solubility curve and the super-solubility curve.

12. The method of forming the organic thin film according to claim 11, further comprising (4) lowering the temperature TS from the temperature T2.

13. A method of forming an organic thin film, the method comprising:
(1) preparing an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region connected thereto on one surface, the solution constricting region having a width smaller than a width of the solution accumulating region;
(2) supplying the organic solution to the solution accumulating region and the solution constricting region to allow a temperature TS of the organic solution to be a temperature T2 positioned between the solubility curve and the super-solubility curve, and a vapor pressure P in an environment surrounding the organic solution to be a saturated vapor pressure at the temperature T2; and
(3) lowering the vapor pressure P.

14. The method of forming the organic thin film according to any one of claims 11 to 13, wherein the organic thin film is a single crystal.

15. The method of forming the organic thin film according to any one of claims 11 to 13, wherein the solution accumulating region and the solution constricting region are lyophilic with respect to the organic solution, and other region is liquid-repellent with respect to the organic solution.

16. The method of forming the organic thin film according to any one of claims 11 to 13, wherein the film-formation substrate has a plurality of sets of the solution accumulating region and the solution constricting region.

17. The method of forming the organic thin film according to any one of claims 11 to 13, wherein the organic material is an organic semiconductor material.

18. A method of manufacturing an organic device, the method, in order to manufacture an organic device using an organic thin film, comprising:
(1) preparing an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region connected thereto on one surface, the solution constricting region having a width smaller than a width of the solution accumulating region;
(2) supplying the organic solution to the solution accumulating region and the solution constricting region to allow a temperature TS of the organic solution to be a temperature T1 positioned on a side higher in temperature than the solubility curve, and a vapor pressure P in an environment surrounding the organic solution to be a saturated vapor pressure at the temperature T1; and
(3) lowering the temperature TS from the temperature T1 to a temperature T2 positioned between the solubility curve and the super-solubility curve.

19. A method of manufacturing an organic device, the method, in order to manufacture an organic device using an organic thin film, comprising:
(1) preparing an organic solution containing a solvent and an organic material dissolved therein, a solubility curve (concentration versus temperature) as well as a super-solubility curve (concentration versus temperature) concerning the organic solution, and a film-formation substrate having a solution accumulating region and a solution constricting region connected thereto on one surface, the solution constricting region having a width smaller than a width of the solution accumulating region;
(2) supplying the organic solution to the solution accumulating region and the solution constricting region to allow a temperature TS of the organic solution to be a temperature T2 positioned between the solubility curve and the super-solubility curve, and a vapor pressure P in an environment surrounding the organic solution to be a saturated vapor pressure at the temperature T2; and
(3) lowering the vapor pressure P.
